# EUROPEAN PATENT APPLICATION

(11) **EP 4 770 355 A1**
(43) Date of publication of application: **01.07.2026**
(21) Application number: 25216361.3
(22) Date of filing: 17.11.2025
(51) Int. Cl.: H10H 29/14, H10H 29/80, H10H 29/853, H10H 29/30

(54) **DISPLAY APPARATUS**

(30) Priority: 02.12.2024 KR 20240176298
(71) Applicant: Samsung Electronics Co., Ltd., Suwon-si, Gyeonggi-do 16677 (KR)
(72) Inventor: LEE, Donghyeong, 16677 Suwon-si (KR); KIM, Juhyun, 16677 Suwon-si (KR); PARK, Kiwon, 16677 Suwon-si (KR); SIM, Jaein, 16677 Suwon-si (KR); LEE, Shiyoung, 16677 Suwon-si (KR); JEON, Joonwoo, 16677 Suwon-si (KR)
(74) Representative: Marks & Clerk LLP

(57) **Abstract**

A display apparatus may include a semiconductor stack including: a first conductivity-type semiconductor base layer; and light-emitting diode (LED) cells on a lower surface of the first conductivity-type semiconductor base layer. The display apparatus may further include a spacer on a side surface and a lower surface of the LED cells, the spacer including an inclined outer sidewall; a reflective electrode on the spacer and connected to a region of the first conductivity-type semiconductor base layer between the LED cells; a gap-fill insulating layer on a lower surface of the semiconductor stack and on the at least one reflective electrode; a connection electrode connected to the second conductivity-type semiconductor layer through a contact hole penetrating the gap-fill insulating layer, the reflective electrode, and the spacer; and an insulating liner disposed along an inner sidewall of the contact hole, and electrically insulating the connection electrode and the reflective electrode.

## Description

### FIELD

Some embodiments of the present disclosure relate to a micro light emitting diode (LED) light source module, a display apparatus equipped with the same, and a manufacturing method thereof.

### BACKGROUND

Semiconductor LEDs may be used as light sources for lighting devices as well as light sources for various electronic products. In particular, LEDs may be widely used as light sources for various display apparatuses such as TVs, mobile phones, PCs, notebook PCs, PDAs, or the like.

Some display apparatuses may be mainly composed of a display panel comprised of a liquid crystal display (LCD), and a backlight, but recently, LEDs have been developed in a form that does not require a separate backlight by using LEDs as pixels. Such display apparatuses may be miniaturized, and may implement high-brightness display apparatuses with superior luminous efficiency, as compared to LCDs.

### SUMMARY

According to some embodiments of the present disclosure, a display apparatus having excellent luminous efficiency may be provided.

According to some embodiments of the present disclosure, an LED module light source having excellent luminous efficiency may be provided.

According to some embodiments of the present disclosure, a method for manufacturing an LED module light source having excellent luminous efficiency may be provided.

According to some embodiments of the present disclosure, a display apparatus may be provided and include: a semiconductor stack including: a first conductivity-type semiconductor base layer including an upper surface configured as a light emitting surface; and a light-emitting diode (LED) cell on a lower surface of the first conductivity-type semiconductor base layer, the LED cell including an active layer and a second conductivity-type semiconductor layer, sequentially stacked on the lower surface of the first conductivity-type semiconductor base layer; a spacer on a side surface and a lower surface of the LED cell, the spacer including an inclined outer sidewall; a reflective electrode on the spacer and connected to the first conductivity-type semiconductor base layer; a gap-fill insulating layer on a lower surface of the semiconductor stack and on the reflective electrode; a connection electrode connected to the second conductivity-type semiconductor layer of the LED cell through a contact hole penetrating the gap-fill insulating layer, the reflective electrode, and the spacer; and an insulating liner disposed along an inner sidewall of the contact hole, and electrically insulating the connection electrode and the reflective electrode.

According to some embodiments of the present disclosure, a display apparatus may be provided and include: a pixel array of a plurality of pixel units, each of the plurality of pixel units including a plurality of sub-pixels, wherein the pixel array includes: a semiconductor stack including: a first conductivity-type semiconductor base layer including an upper surface configured as a light emitting surface; and a light-emitting diode (LED) cell on a lower surface of the first conductivity-type semiconductor base layer, the LED cell including an active layer and a second conductivity-type semiconductor layer; a spacer on a side surface of the LED cell and a lower surface of the LED cell, the spacer including an inclined outer sidewall; a reflective electrode on the spacer and connected to a region of the first conductivity-type semiconductor base layer; a gap-fill insulating layer on a lower surface of the semiconductor stack and on the reflective electrode; a connection electrode connected to the second conductivity-type semiconductor layer of the LED cell through a contact hole penetrating the gap-fill insulating layer, the reflective electrode, and the spacer; and an insulating liner extending from a lower end of the contact hole to the lower surface of the LED cell along an inner sidewall of the contact hole, wherein a region of the lower surface of the first conductivity-type semiconductor base layer between the LED cell includes: first regions in which the spacer is located; and a second region recessed between the first regions, and wherein and the reflective electrode is connected to the second region along an outer sidewall of the spacer.

According to some embodiments of the present disclosure, a display apparatus may be provided and include: a pixel array of a plurality of pixel units, each of the plurality of pixel units including a plurality of sub-pixels, wherein the pixel array includes: a semiconductor stack including: a first conductivity-type semiconductor base layer including an upper surface configured as a light emitting surface, and a light-emitting diode (LED) cell on a lower surface of the first conductivity-type semiconductor base layer, and the LED cell including an active layer and a second conductivity-type semiconductor layer; a spacer on a side surface of the LED cell and a lower surface of the LED cell, the spacer including an inclined outer sidewall; a reflective electrode on the spacer and connected to a region of the first conductivity-type semiconductor base layer; a gap-fill insulating layer on a lower surface of the semiconductor stack and on the reflective electrode; a connection electrode connected to the second conductivity-type semiconductor layer of the LED cell through a contact hole penetrating the gap-fill insulating layer, the reflective electrode, and the spacer; and an insulating liner extending from a lower end of the contact hole along an inner sidewall of the contact hole, the insulating liner separated from the lower surface of each of the LED cell by the spacer.

According to some embodiments of the present disclosure, an LED light source module may be provided and include: a semiconductor stack including a first conductivity-type semiconductor base layer including an upper surface configured as a light emitting surface, and a plurality of LED cells on a lower surface of the first conductivity-type semiconductor base layer, wherein each of the plurality of LED cells includes, at least, an active layer and a second conductivity-type semiconductor layer, sequentially stacked on the lower surface of the first conductivity-type semiconductor base layer. The LED light source module may further include: at least one spacer on a side surface and a lower surface of each of the plurality of LED cells and including an inclined outer sidewall; at least one reflective electrode on the at least one spacer and connected to a region of the first conductivity-type semiconductor base layer between the plurality of LED cells; at least one gap-fill insulating layer on a lower surface of the semiconductor stack and on the at least one reflective electrode; at least one connection electrode connected to the second conductivity-type semiconductor layer of each of the plurality of LED cells through at least one contact hole penetrating the at least one gap-fill insulating layer, the at least one reflective electrode, and the at least one spacer; and at least one insulating liner disposed along an inner sidewall of the at least one contact hole, and insulating the at least one connection electrode and the at least one reflective electrode.

According to an aspect of the present disclosure, a method for manufacturing an LED light source module includes sequentially growing a first conductivity-type semiconductor layer, an active layer, and a second conductivity-type semiconductor layer on a substrate to form a semiconductor stack; etching a portion of the second conductivity-type semiconductor layer, a portion of the active layer, and a portion of the first conductivity-type semiconductor layer to form a plurality of LED cells; forming at least one spacer on a side surface and a lower surface of each of the plurality of LED cells and including an inclined sidewall, wherein a region of the first conductivity-type semiconductor layer between the plurality of LED cells is exposed; forming at least one reflective electrode on the at least one spacer and connected to the exposed region of the first conductivity-type semiconductor layer between the plurality of LED cells; forming at least one gap-fill insulating layer on the at least one reflective electrode on a lower surface of the semiconductor stack; forming at least one contact hole penetrating the at least one gap-fill insulating layer, the at least one reflective electrode, and the at least one spacer; conformally forming a liner material layer on an upper surface of the at least one gap-fill insulating layer and an inner surface of the at least one contact hole; removing a portion of the liner material layer on the upper surface of the at least one gap-fill insulating layer and a bottom of the at least one contact hole using an etching process, to form at least one insulating liner on an inner sidewall of the at least one contact hole; and forming at least one connection electrode connected to the second conductivity-type semiconductor layer of each of the plurality of LED cells in the at least one contact hole.

At least some of the above and other features of the invention are set out in the claims.

### BRIEF DESCRIPTION OF DRAWINGS

The above and other aspects, features, and advantages of certain embodiments of the present disclosure may be more apparent from the following description, taken in conjunction with the accompanying drawings, in which:
FIG. 1 is a schematic perspective view of a display apparatus according to an embodiment.
FIG. 2 is a partial enlarged plan view illustrating a portion "A" of the display apparatus illustrated in FIG. 1.
FIG. 3 is a schematic cross-sectional view illustrating a display apparatus according to an embodiment.
FIG. 4 is a partial enlarged view illustrating a portion "B" of the display apparatus illustrated in FIG. 3.
FIG. 5 illustrates a driving circuit implemented in a display apparatus according to an embodiment.
FIG. 6 is a cross-section view illustrating a LED light source module employed in a display apparatus according to an embodiment.
FIG. 7 is a cross-section view illustrating a LED light source module employed in a display apparatus according to an embodiment.
FIG. 8 is a schematic cross-sectional view illustrating a display apparatus according to an embodiment.
FIG. 9 is a partial enlarged view illustrating a portion "B3" of the display apparatus illustrated in FIG. 8.
FIGS. 10A to 10E are cross-sectional views illustrating some processes of a method for manufacturing a display apparatus according to an embodiment.
FIGS. 11A to 11C are cross-sectional views illustrating formation of an LED cell.
FIGS. 12A to 12D are cross-sectional views illustrating an example of the process of FIG. 10C (particularly, formation of a spacer).
FIGS. 13A to 13D are cross-sectional views illustrating an example of a spacer formation process that are employed in a manufacturing method according to an embodiment.
FIGS. 14A and 14B are cross-sectional views illustrating an example of the process of FIG. 10D (particularly, formation of a reflective electrode).
FIGS. 15A to 15D are cross-sectional views illustrating an example of the process of FIG. 10E (particularly, formation of a connection electrode).
FIGS. 16A to 16D are cross-sectional views illustrating an example of a connection electrode formation process that are employed in a manufacturing method according to an embodiment.
FIGS. 17A to 17C are cross-sectional views illustrating other processes of a method for manufacturing a display apparatus according to an embodiment.
FIG. 18 is a schematic diagram of an electronic device including a display apparatus according to an embodiment.

### DETAILED DESCRIPTION

Hereinafter, non-limiting example embodiments of the present disclosure will be described in detail with reference to the attached drawings.

It will be understood that when an element or layer is referred to as being "on," "connected to," or "coupled to" another element or layer, it can be directly on, connected to, or coupled to the other element or layer or one or more intervening elements or layers may be present. In contrast, when an element or layer is referred to as being "directly on," "directly connected to," or "directly coupled to" another element or layer, there are no intervening elements or layers present.

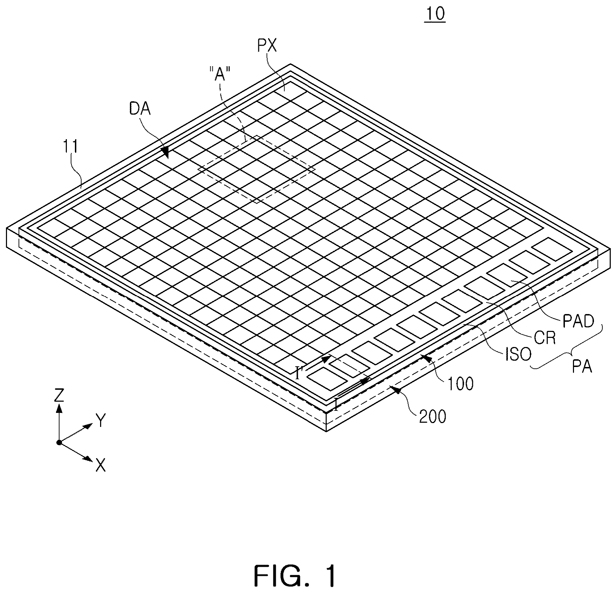

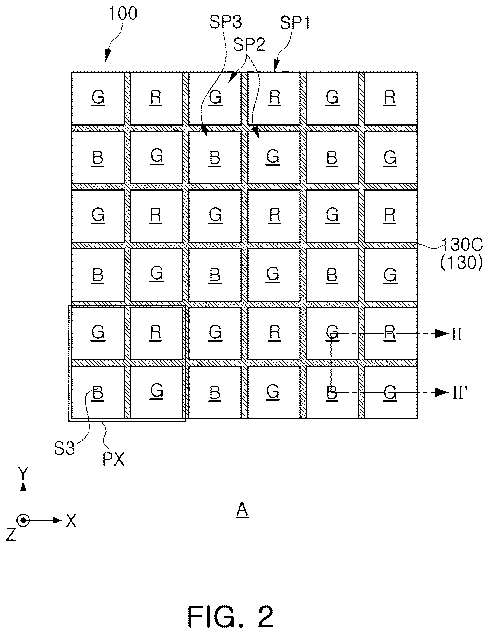

FIG. 1 is a schematic perspective view of a display apparatus according to an embodiment, and FIG. 2 may be a cross-sectional view taken along an X-Y plane of a portion "A" of the display apparatus of FIG. 1.

Referring to FIGS. 1 and 2, a display apparatus 10 according to the present embodiment may include a circuit board 200 including driving circuits, and a pixel array 100 disposed on the circuit board 200 and having a plurality of pixels PX disposed therein. In addition, the display apparatus 10 may further include a frame 11 surrounding the circuit board 200 and the pixel array 100.

The driving circuits of the circuit board 200 may include thin film transistor (TFT) cells. In some embodiments, the circuit board 200 may additionally include other circuits, in addition to the driving circuits for the display apparatus 10. In some embodiments, the circuit board 200 may include a flexible board, and the display apparatus 10 may be implemented as a display apparatus having a curved profile.

The pixel array 100 may include a display region DA and a peripheral region PA located at least on one side of the display region DA. The display region DA may include an LED light source module for display. The pixel array 100 may include the display region DA in which a plurality of pixels PX are arranged. The peripheral region PA may include pad regions PAD, a connection region CR connecting the plurality of pixels PX and the pad regions PAD, and an edge region ISO.

Each of the plurality of pixels PX may include first to third sub-pixels SP1, SP2, and SP3 configured to emit light of different colors to provide a color image. For example, the first to third sub-pixels SP1, SP2, and SP3 may be configured to emit red (R) light, green (G) light, and blue (B) light, respectively.

In some embodiments, in each of the pixels PX (also referred to as "pixel unit"), the first to third sub-pixels SP1, SP2, and SP3 may be disposed in a Bayer pattern. As illustrated in FIG. 2, each of the pixels PX may include a first sub-pixel SP1 and a third sub-pixel SP3 (e.g., red (R) and blue (B)) disposed in a first diagonal direction, and two second sub-pixels (SP2) (e.g., green (G)) disposed in a second diagonal direction, intersecting the first diagonal direction e.g. wherein the second diagonal direction is different to the first diagonal direction. In the present embodiment, each of the pixels PX is illustrated as having the first to third sub-pixels SP1, SP2, and SP3 disposed in a 2×2 Bayer pattern. However, embodiments of the present disclosure are not limited thereto, and in other embodiments, each of the pixels PX may be configured in a different arrangement, such as 3×3 or 4×4. In some embodiments, each of the pixels PX may include a sub-pixel configured to emit a color, other than the illustrated colors (R, G, B) such as, for example, yellow light.

In the pixel array 100 of FIG. 1, the plurality of pixels PX are illustrated as disposed in a 15×15 configuration, but the number of rows and columns may be implemented as any suitable number such as, for example, 1,024×768 or 1,800×1,350. For example, depending on desired resolution, the plurality of pixels PX may have a different arrangement.

The frame 11 may be a guide structure surrounding the pixel array 100. The frame 11 may include at least one of a polymer material, a ceramic material, a semiconductor material, or metal material. For example, the frame 11 may include a black matrix. The frame 11 is not limited to the black matrix, and may include a white matrix or a structure of a different color depending on the purpose of the display apparatus 10. For example, the white matrix may include a reflective material or a scattering material. The display apparatus 10 of FIG. 1 is illustrated as having a rectangular planar structure, but may have a different shape in some embodiments.

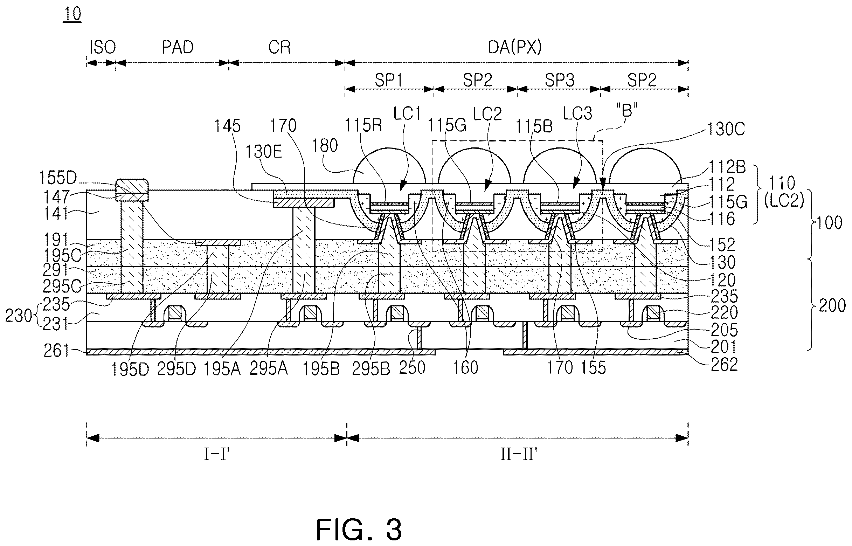

A plurality of LED cells LC1, LC2, and LC3 (see FIG. 3) may be provided. The plurality of LED cells (e.g., the first to third LED cells LC1, LC2, and LC3) may be micro LED structures, respectively, and may be disposed to correspond to the first to third sub-pixels SP1, SP2, and SP3, respectively. The plurality of LED cells (e.g., the first to third LED cells LC1, LC2, and LC3) may be disposed in a plurality of rows and a plurality of columns in a plan view (see FIG. 2).

The plurality of LED cells (e.g., the first to third LED cells LC1, LC2, and LC3) may be provided as light sources for the first to third sub-pixels SP1, SP2, and SP3. The first to third sub-pixels SP1, SP2, and SP3 may be configured to emit light of different colors, as described above. In the present embodiment, with reference to FIG. 3, the plurality of LED cells (e.g., the first to third LED cells LC1, LC2, and LC3) may include active layers (e.g., a first active layer 115R, a second active layer 115G, and a third active layer 115B) that emit light of different wavelengths from each other. Each of the LED cells LC1 (e.g., first LED cells) may include a first active layer 115R configured to emit red light, for example, light having a wavelength of 620 nm to 660 nm, and may be provided as a red sub-pixel (e.g., the first sub-pixel SP1). Each of LED cells LC2 (e.g., second LED cells) may include a second active layer 115G configured to emit green light, for example, light having a wavelength of 510 nm to 550 nm, and may be provided as a green sub-pixel (e.g., the second sub-pixel SP2). Each of LED cells LC3 (e.g., third LED cells) may include a third active layer 115B configured to emit blue light, for example, light having a wavelength of 430 nm to 480 nm, and may be provided as a blue sub-pixel (e.g., the third sub-pixel SP3).

The first to third active layers 115R, 115G, and 115B may have different light-emitting efficiencies depending on an emission wavelength. To smoothly reproduce color of the display apparatus 10, an area of the LED cell may be changed or a configuration of the active layer (e.g., the number of quantum wells) may be changed such that a deviation between amounts of light emitted from different sub-pixels (e.g., the first to third sub-pixels SP1, SP2, and SP3) is reduced.

FIG. 3 may be a partial enlarged cross-sectional view of a display apparatus according to an embodiment, illustrating a partial cross-section along a line I-I' of the peripheral region PA of the display apparatus of FIG. 1 and a partial cross-section along a line II-II' of the display region DA of the display apparatus of FIG. 2.

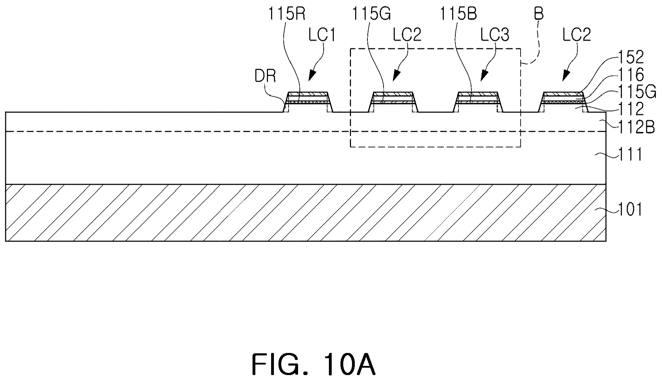

As described above, the first to third LED cells LC1, LC2, and LC3 may be a part of a semiconductor stack 110 configured to emit light of different wavelengths from each other, and may be provided as a light source for the first to third sub-pixels SP1, SP2, and SP3. The semiconductor stack 110 of the first to third LED cells LC1, LC2, and LC3 employed in the present embodiment may include a nitride epitaxial layer grown on the same substrate (see FIG. 10A).

As illustrated in FIG. 3, the semiconductor stack 110 may have a first surface (or lower surface) facing the circuit board 200, and a second surface (or upper surface) located opposite thereto. In the present embodiment, the semiconductor stack 110 may include a first conductivity-type semiconductor base layer 112B providing the second surface of the semiconductor stack 110, and the plurality of LED cells (e.g., the first to third LED cells LC1, LC2, and LC3) disposed on a lower surface of the first conductivity-type semiconductor base layer 112B. In this case, an upper surface of the first conductivity-type semiconductor base layer 112B may be provided as the second surface of the semiconductor stack 110 (e.g., a light emitting surface).

The plurality of LED cells (e.g., the first to third LED cells LC1, LC2, and LC3) may include, at least, the active layers (e.g., the first active layer 115R, the second active layer 115G, and the third active layer 115B) and a second conductivity-type semiconductor layer 116 stacked on the lower surface of the first conductivity-type semiconductor base layer 112B. The first conductivity-type semiconductor base layer 112B may be a base layer shared by the first to third LED cells LC1, LC2, and LC3, and may provide a contact region (e.g., an n-side contact region) driving the plurality of LED cells (e.g., the first to third LED cells LC1, LC2, and LC3). In addition, the first conductivity-type semiconductor base layer 112B may have an appropriately small thickness to reduce a light leakage effect. In some embodiments, a thickness of the first conductivity-type semiconductor base layer 112B may be in the range of 0.1 µm to 2 µm.

Each of the plurality of LED cells (e.g., the first to third LED cells LC1, LC2, and LC3) employed in the present embodiment may further include a first conductivity-type semiconductor layer 112 between the first conductivity-type semiconductor base layer 112B and the active layers (e.g., the first active layer 115R, the second active layer 115G, and the third active layer 115B). The first conductivity-type semiconductor layer 112 may be a portion obtained by etching the first conductivity-type semiconductor base layer 112B. The active layers (e.g., the first active layer 115R, the second active layer 115G, and the third active layer 115B) of each of the first to third LED cells LC1, LC2, and LC3 may be configured to emit light of different wavelengths from each other (e.g., red, green, blue). In the present embodiment, the first to third active layers 115R, 115G, and 115B of each of the first to third LED cells may include quantum well layers having different amounts of indium.

The first conductivity-type semiconductor base layer 112B and the first conductivity-type semiconductor layer 112 may each be a nitride epitaxial layer having a composition of n-type InₓAl_{y}Ga_{1-x-y}N (0≤x<1, 0≤y<1, 0=x+y<1). For example, the first conductivity-type semiconductor layer 112 may be an n-type nitride (e.g., n-GaN) layer doped with silicon (Si), germanium (Ge), or carbon (C). In particular, the first conductivity-type semiconductor base layer 112B may include a high-concentration n-type nitride (n⁺-GaN) layer providing the contact region. The second conductivity-type semiconductor layer 116 may be a nitride semiconductor layer having a composition of p-type InₓAl_{y}Ga_{1-x-y}N (0≤x<1, 0≤y<1, 0≤x+y<1). For example, the second conductivity-type semiconductor layer 116 may be a p-type nitride (p-GaN) layer doped with magnesium (Mg) or zinc (Zn). Each of the first conductivity-type semiconductor layer 112 and the second conductivity-type semiconductor layer 116 may be formed as a single layer, but may also include a plurality of layers having different characteristics such as a doping concentration, a composition, or the like.

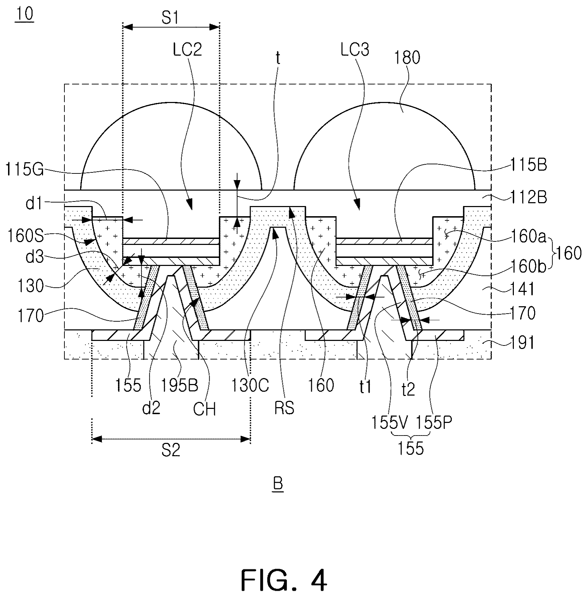

Referring to FIGS. 3 and 4, the plurality of LED cells (e.g., the first to third LED cells LC1, LC2, and LC3) may include a contact electrode 152 located on the second conductivity-type semiconductor layers 116. The contact electrode 152 may include a transparent electrode. The transparent electrode may be one from among a transparent conductivity-type oxide layer or a nitride layer. For example, the transparent electrode may be at least one selected from among indium tin oxide (ITO), zinc-doped indium tin oxide (ZITO), zinc indium oxide (ZIO), gallium indium oxide (GIO), zinc tin oxide (ZTO), fluorine-doped tin oxide (FTO), aluminium-doped zinc oxide (AZO), gallium-doped zinc oxide (GZO), In₄Sn₃O₁₂, and Zn₍₁₋ₓ₎MgₓO (zinc magnesium oxide, 0≤x≤1).

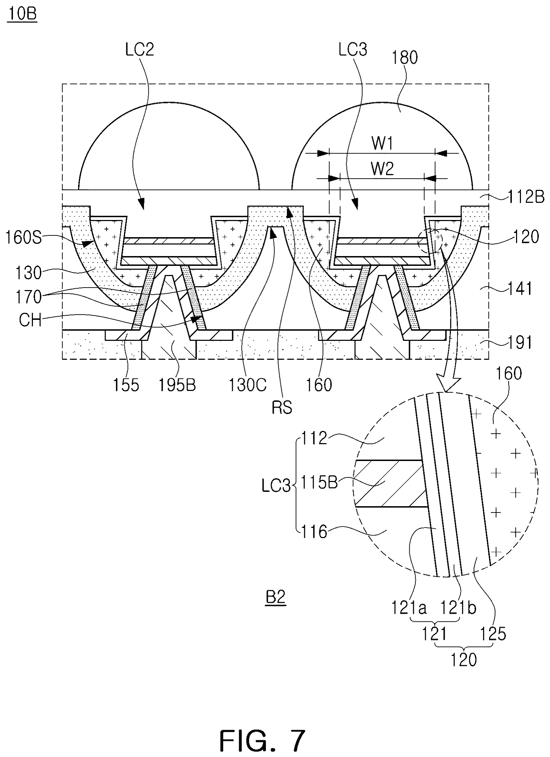

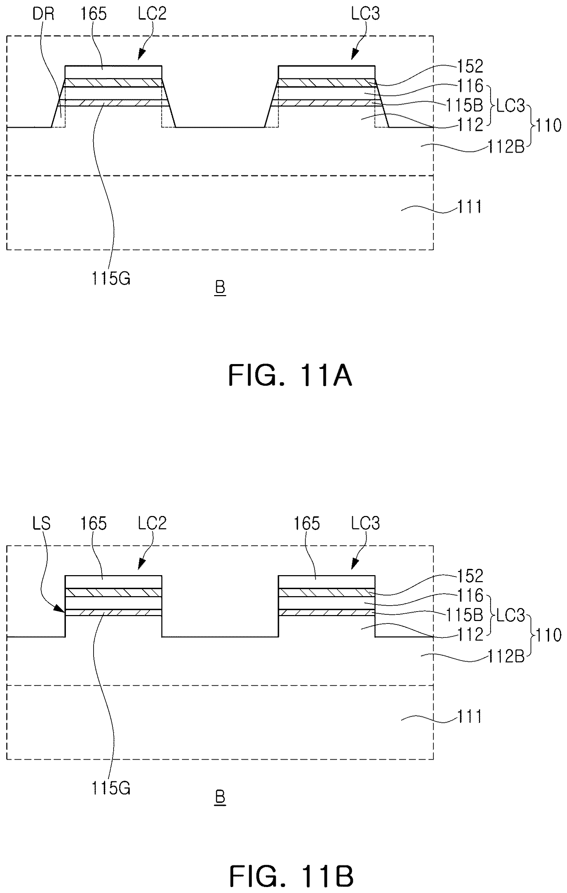

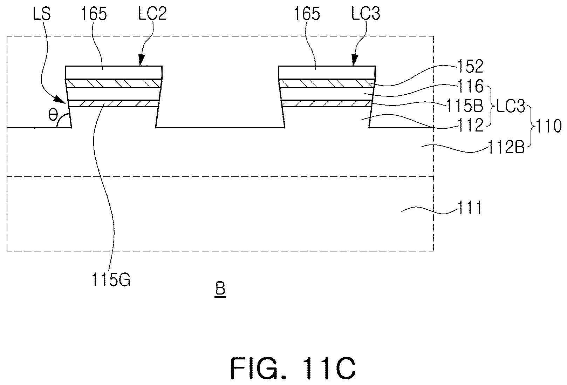

The first to third LED cells LC1, LC2, and LC3 employed in the present embodiment may have a side surface, nearly perpendicular to the lower surface of the first conductivity-type semiconductor base layer 112B. For example, the side surfaces of the first to third LED cells LC1, LC2, and LC3 may have an inclination angle ranging from 85° to 95°. The side surfaces of the first to third LED cells LC1, LC2, and LC3, nearly perpendicular thereto, may be obtained by an etching process (e.g., see FIGS. 11A and 11B) that removes a damaged layer on the side surfaces of the LED cells. This etching process may remove a defective region that causes leakage current. In some embodiments, the lower surface of the first conductivity-type semiconductor base layer 112B (or upper surface of a substrate 101 (see FIG. 10A)) may be a (0001) crystal plane, and the side surfaces of each of the first to third LED cells LC1, LC2, and LC3 may be m-planes. In some embodiments, by applying an additional etching process (see FIG. 11C), the side surfaces of the first to third LED cells LC1, LC2, and LC3 may have an inclination angle of less than 90° with respect to the lower surface of the first conductivity-type semiconductor base layer 112B. As a result, the first to third LED cells LC1, LC2, and LC3 may have a structure advantageous for light extraction (see FIG. 7).

Referring to FIGS. 3 and 4, the pixel array 100 may include a reflective structure configured to emit light to upper surfaces (e.g., light emitting surface) of the first to third LED cells LC1, LC2, and LC3.

The reflective structure employed in the present embodiment may include a spacer 160 having an inclined outer sidewall (e.g., an inclined side surface 160S which may be oriented at one or more angles, or over a range of angles, between a horizontal direction, which is parallel to the lower surface of the first conductivity-type semiconductor base layer 112B, and a vertical direction, which is perpendicular to the lower surface of the first conductivity-type semiconductor base layer 112B), and a reflective electrode 130 connected to the first conductivity-type semiconductor base layer 112B. In a comparative embodiment, when a reflective electrode is formed alongside surfaces of LED cells, perpendicular thereto, light may be trapped in the LED cells, and light may not be effectively extracted at a desired narrow beam angle. According to embodiments, the spacer 160 having the inclined side surface 160S on the side and lower surfaces of the plurality of LED cells (e.g., the first to third LED cells LC1, LC2, and LC3) may be introduced to improve a light extraction efficiency by the reflective electrode 130 and further increase a light collection effect.

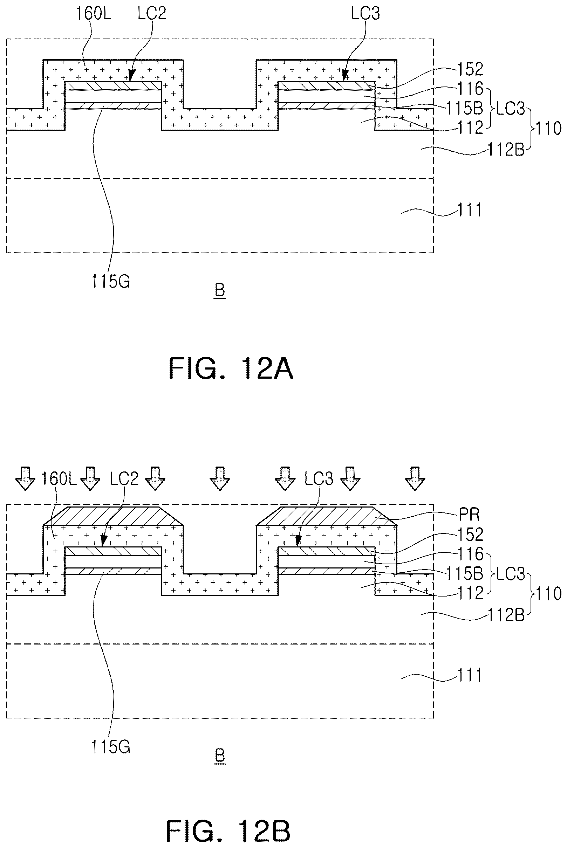

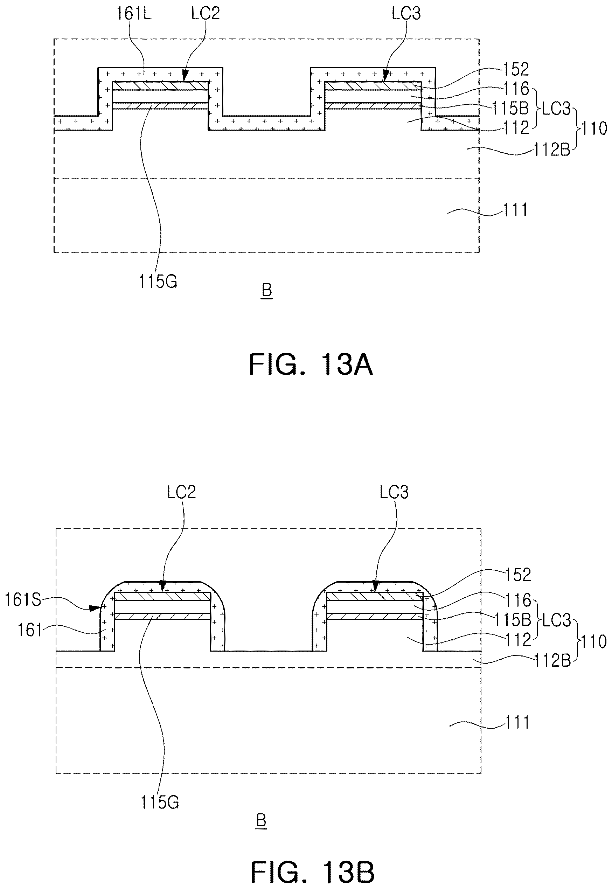

Referring to FIG. 4, the spacer 160 employed in the present embodiment may include a first portion 160a covering the side surface of each of the plurality of LED cells (e.g., the first to third LED cells LC1, LC2, and LC3), and a second portion 160b covering the lower surface of each of the plurality of LED cells (e.g., the first to third LED cells LC1, LC2, and LC3). As will be described below with reference to FIGS. 12A to 12D and with reference to FIGS. 13A to 13D, formation of the spacer 160 may comprise forming a spacer material layer 160L on the lower and side surfaces of the first to third LED cells LC 1, LC2, and LC3, and on the lower surface of the first conductivity-type semiconductor base layer 112B and etching the spacer material layer 160L to form the spacer 160. Consequently, it should be understood that references below to a "thickness" of the spacer 160 refer to a thickness of the spacer 160 on the surface which is covers. The first portion 160a of the spacer 160 may have the inclined side surface 160S based on the lower surface of the first conductivity-type semiconductor base layer 112B. The first portion 160a may have a thickness d1 increasing toward the first conductivity-type semiconductor base layer 112B. This inclined side surface 160S may have a curved portion. In some embodiments, the second portion 160b may have a region having a constant thickness d2, but a flat region of the second portion 160b may be barely observable in a final structure due to a contact hole CH.

Referring to FIG. 4, a thickness d3 of a portion of the spacer 160 adjacent to a lower edge of each of the plurality of LED cells (e.g., the first to third LED cells LC1, LC2, and LC3) may be smaller than the thickness d1 of the first portion 160a. In the present embodiment, the thickness d3 of the adjacent portion may be smaller than the thickness d2 of the second portion 160b. For example, the spacer 160 may include SiO₂, SiOC, SiON, or SiOCN.

The reflective electrode 130 may be formed to cover the spacer 160. The reflective electrode 130 may have a reflective surface formed according to a surface shape of the spacer 160. The reflective electrode 130 may have reflective structures having a bowl-shape or a bell-shape, enhancing a light capturing effect.

The reflective electrode 130 may be provided as a first electrode for driving the plurality of LED cells (e.g., the first to third LED cells LC1, LC2, and LC3). The reflective electrode 130 may have a contact portion 130C electrically connected to the contact region of the first conductivity-type semiconductor base layer 112B between the plurality of LED cells (e.g., the first to third LED cells LC1, LC2, and LC3). The contact region of the first conductivity-type semiconductor base layer 112B may be provided as a region between the plurality of LED cells (e.g., the first to third LED cells LC1, LC2, and LC3).

In the present embodiment, the contact portion 130C of the reflective electrode 130 may be provided as a common electrode of the plurality of LED cells (e.g., the first to third LED cells LC1, LC2, and LC3). In a plan view, as illustrated in FIG. 2, the reflective electrode 130 (in particular, the contact portion 130C) may have a grid structure or a mesh structure extending in a first horizontal direction (e.g., X-direction) and a second horizontal direction (e.g., Y-direction), intersecting the first horizontal direction (e.g. wherein the second horizontal direction is different to the first horizontal direction), and connected to each other. A side cross-section of the reflective electrode 130 may have an inverted U shape. The reflective electrode 130 may include a reflective electrode material, and may include at least one from among silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), gold (Au), copper (Cu), titanium (Ti), tantalum (Ta), and tungsten (W). In some embodiments, the reflective electrode 130 may include a single-layer structure or a multi-layer structure.

In the present embodiment, the contact region of the first conductivity-type semiconductor base layer 112B may have a recess RS. The recess RS may have a grid structure or a mesh structure extending in the first horizontal direction (e.g., X-direction) and the second horizontal direction (e.g., Y-direction), and connected to each other in a plan view, similar to the contact portion 130C of the reflective electrode 130. The contact portion 130C of the reflective electrode 130 may be connected to a bottom of the recess RS. The bottom of the recess RS may be provided by a first conductivity-type semiconductor layer (e.g., n+-GaN) doped in a high concentration. In the present embodiment, the recess RS may be defined as a region between adjacent spacers 160. The contact region of the first conductivity-type semiconductor base layer 112B between the plurality of LED cells (e.g., the first to third LED cells LC1, LC2, and LC3) may include regions in which the spacer 160 is located, and the recess RS between the regions. A side surface of the spacer 160 may be continuously connected to a side surface of the recess RS. The reflective electrode 130 may be connected to the bottom of the recess RS along the side surface of the spacer 160.

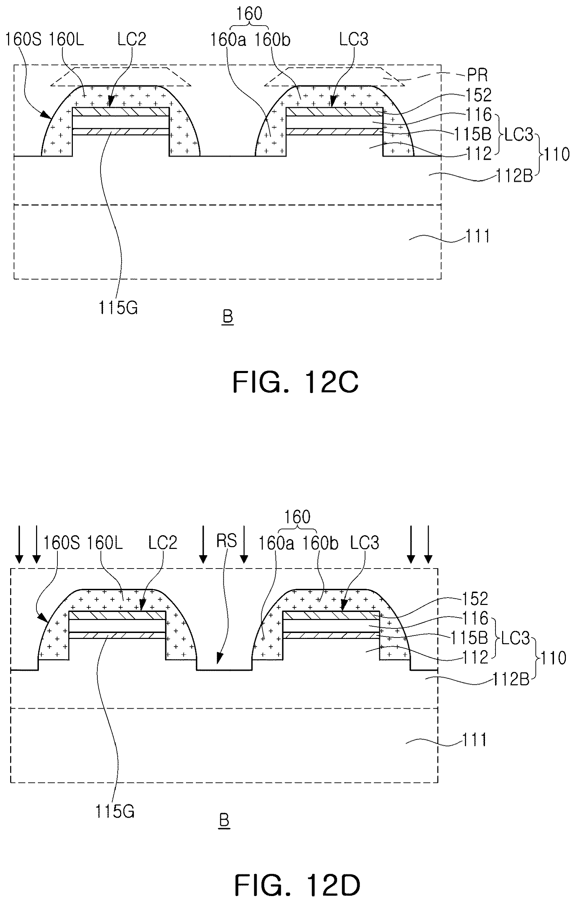

In this manner, in the present embodiment, even though heights of the LED cells (e.g., first to third LED cells LC1, LC2, and LC3) are formed relatively small, the contact region may be exposed by additional etching (see the process of FIG. 12D) for forming the recess RS. As a result, the plurality of LED cells (e.g., the first to third LED cells LC1, LC2, and LC3) may be formed to have a relatively small aspect ratio. For example, the aspect ratio of the plurality of LED cells (e.g., the first to third LED cells LC1, LC2, and LC3) may be 1 or less.

The pixel array 100 may further include a gap-fill insulating layer 141 covering the reflective electrode 130 on the lower surface of the semiconductor stack 110. The gap-fill insulating layer 141 may include a spin-on hardmask (SOH), a flowable oxide (FOX), a Tonen silazen (TOSZ), undoped silica glass (USG), borosilica glass (BSG), phosphosilaca glass (PSG), borophosphosilica glass (BPSG), plasma enhanced tetra ethyl ortho silicate (PETEOS), fluoride silicate glass (FSG), a high density plasma (HDP) oxide, a plasma enhanced oxide (PEOX), a flowable chemical vapor deposition (CVD) (FCVD) oxide, or a combination thereof. The gap-fill insulating layer 141 may be formed using a chemical vapor deposition process, a flowable CVD process, or a spin coating process, respectively. The gap-fill insulating layer 141 may be formed to have a flat upper surface. In some embodiments, even though the gap-fill insulating layer 141 may include a material, identical to a material of the spacer 160 (e.g., silicon oxide), the spacer 160 may be formed to have a structure that is denser than the gap-fill insulating layer 141. For example, such a spacer 160 (e.g., a dense spacer) may be formed by a process such as atomic layer deposition (ALD).

The contact hole CH may penetrate the gap-fill insulating layer 141, the reflective electrode 130, and the spacer 160. A plurality of contact holes CH may be formed to expose a region of the lower surface of the plurality of LED cells (e.g., the first to third LED cells LC1, LC2, and LC3), respectively. The contact hole CH employed in the present embodiment may be formed to penetrate not only the gap-fill insulating layer 141 and the spacer 160, but also the reflective electrode 130. The reflective electrode 130 may be exposed on a sidewall of the contact hole CH.

Referring to FIG. 4, an insulating liner 170 may be disposed on the sidewall of the contact hole CH. The insulating liner 170 may be present in the contact hole CH, and may not be present on a lower surface of the gap-fill insulating layer 141. In the present embodiment, the insulating liner 170 may extend from a lower end of the contact hole CH to the contact electrodes 152. The insulating liner 170 may include SiO₂, SiN, SiCN, SiC, SiCOH, SiON, Al₂O₃, AlN, or a combination thereof.

Connection electrodes 155 may be respectively connected to the contact electrodes 152 of the plurality of LED cells (e.g., the first to third LED cells LC1, LC2, and LC3) through the contact holes CH. In the present embodiment, the connection electrodes 155 may be used as the other electrode for driving the plurality of LED cells (e.g., the first to third LED cells LC1, LC2, and LC3), together with the reflective electrode 130, and unlike the reflective electrode 130 which may be a common electrode, may be provided as an individual electrode. In some embodiments, a connection electrode 155 may include an electrode material, similar to an electrode material of the reflective electrode 130. For example, the connection electrode 155 may include at least one from among silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), gold (Au), copper (Cu), titanium (Ti), tantalum (Ta), and tungsten (W). In some embodiments, the connection electrode 155 may include a single-layer structure or a multi-layer structure.

In the present embodiment, the reflective electrode 130 may be exposed at an inner sidewall of the contact hole CH, but the connection electrodes 155 may be electrically separated from the reflective electrode 130 by the insulating liner 170. In this manner, the insulating liner 170 may prevent unwanted short circuit between the reflective electrode 130 and the connection electrodes 155.

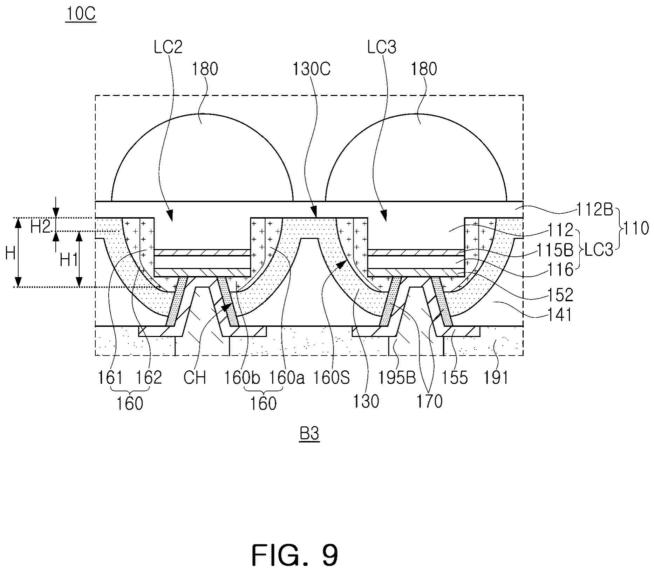

In addition, the reflective electrode 130 may be formed entirely on a cover portion (e.g., a second portion 160b; see FIG. 9) of the spacer 160 except for the contact hole CH. As a result, the reflective electrode 130 introduced in the present embodiment may be configured to minimize light leakage on the lower surface of each of the plurality of LED cells (e.g., the first to third LED cells LC1, LC2, and LC3).

In the present embodiment, the insulating liner 170 may be formed by a self-alignment process using anisotropic etching without a separate mask (see FIGS. 14D and 14E). As a result, in a cross-sectional structure, thicknesses of both side portions of the insulating liner 170 may not have a large deviation. As illustrated in FIG. 4, the insulating liner 170 may have both side portions facing each other in the contact hole CH, and a thickness deviation (t1-t2) of the portions may hardly occur. For example, the thickness deviation (t1-t2) of the facing portions may be 10% or less.

In the present embodiment, the connection electrode 155 may include a via 155V located in the contact hole CH, and a pad 155P connected to the via 155V and located on the lower surface of the gap-fill insulating layer 141. The pad 155P of the connection electrode 155 may have a width S2, greater than a width S1 of each of the plurality of LED cells (e.g., the first to third LED cells LC1, LC2, and LC3). In this manner, the pad 155P of the connection electrode 155 may be provided as a complementary reflective structure for a small amount of light that leaks horizontally (e.g., light that leaks through the insulating liner).

Referring to FIG. 3, the reflective electrode 130 may have an extension portion 130E extending from the display region DA to the peripheral region PA. In the connection region CR, a common electrode 145 may be disposed on the extension portion 130E of the reflective electrode 130. A pad electrode 147 may be located in the pad region PAD, and, in a similar manner to the common electrode 145, may be located on the gap-fill insulating layer 141, and may be connected to a bonding pad 199 for connecting to an external circuit on the pad electrode 147.

An upper bonding structure may include an upper bonding insulating layer 191 disposed on the lower surface of the gap-fill insulating layer 141, and upper bonding electrodes 195A-D. Upper bonding electrodes 195A and 195B are electrically connected to the reflective electrode 130 and the connection electrodes 155, respectively, on the upper bonding insulating layer 191. The upper bonding electrodes 195A-D may have a shape like a post. Lower surfaces of the upper bonding electrodes 195A-D may be substantially coplanar with a lower surface of the upper bonding insulating layer 191. This coplanar surface may be provided as a bonding surface for bonding to the circuit board 200 as the lower surface of the pixel array 100. The upper bonding electrodes 195A-D may include a conductive material such as, for example, copper (Cu). For example, the upper bonding insulating layer 191 may include at least one from among SiO, SiN, SiCN, SiOC, SiON, or SiOCN.

As described above, the common electrode 145 and the pad electrode 147 may be disposed in the connecting region CR and the pad regions PAD, respectively. The common electrode 145 may be provided as a common electrode structure for driving the first to third LED cells LC1, LC2, and LC3, together with the reflective electrode 130. The pad electrode 147 may be disposed in the pad regions PAD, and may be connected to the bonding pad 199 for connecting to an external circuit on the pad electrode 147.

The common electrode 145 and the pad electrode 147 may include at least one of a conductive material, such as, for example, silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), or gold (Au). For example, the bonding pad 199 may include at least one from among gold (Au), silver (Ag), and nickel (Ni).

In the present embodiment, depending on a connection target, the upper bonding electrodes may include a first upper bonding electrode (e.g., the upper bonding electrode 195A) electrically connected to the reflective electrode 130, second upper bonding electrodes (e.g., the upper bonding electrode 195B) electrically connected to the connection electrodes 155, respectively, and a third upper bonding electrode (e.g., the upper bonding electrode 195C) connected to the pad electrode 147.

Referring to FIG. 3, the first upper bonding electrode (e.g., the upper bonding electrode 195A) may penetrate the upper bonding insulating layer 191 and the gap-fill insulating layer 141 to be landed on (e.g., to contact) the common electrode 145, and may be commonly connected to one side (e.g., the first conductivity-type semiconductor base layer 112B) of each of the first to third LED cells LC1, LC2, and LC3 through the common electrode 145 and the reflective electrode 130. The second upper bonding electrodes 195B may be landed (e.g., contact) on the connection electrode 155 by penetrating the upper bonding insulating layer 191, and may be individually connected to the other side (e.g., the second conductivity-type semiconductor layer 116) of each of the first to third LED cells LC1, LC2, and LC3 through the connection electrode 155 and the contact electrode 152. In addition, the third upper bonding electrode 195C may be landed on (e.g., contact) the pad electrode 147 by penetrating the upper bonding insulating layer 191 and the gap-fill insulating layer 141, and may be connected to the bonding pad 199 for connecting to an external circuit through the pad electrode 147.

Referring to FIG. 3, the circuit board 200 employed in the present embodiment may include a device board (e.g., a device substrate 201) on which elements 220 for a driving circuit are disposed, and a lower bonding structure disposed on the device board (e.g., the device substrate 201). The circuit board 200 may include an interlayer connection structure 230 between the device substrate 201 and the lower bonding structure. The interlayer connection structure 230 may include an interconnection insulation layer 231 on the device substrate 201, and an interconnection circuit 235 electrically connected to the elements 220 in the interconnection insulation layer 231. The elements 220 for the driving circuit may include thin film transistor (TFT) cells.

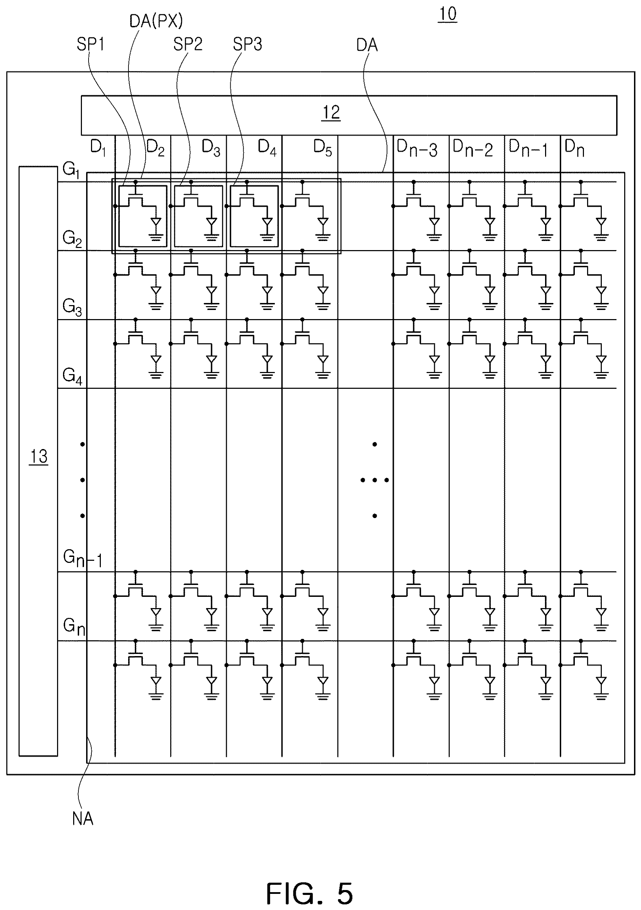

The device substrate 201 may be a semiconductor substrate including impurity regions including source/drain regions 205. The device substrate 201 may include, for example, a semiconductor such as silicon (Si) or germanium (Ge), or a compound semiconductor such as SiGe, SiC, GaAs, InAs, or InP. The driving circuit may include a circuit for controlling driving of a pixel, particularly a sub-pixel. A source region among the source/drain regions 205 of the TFT cells may be electrically connected to one side of the first to third LED cells LC1, LC2, and LC3 through the interlayer connection structure 230 and the lower bonding structure. For example, a drain region among the source/drain regions 205 of the TFT cells may be connected to a data line through the interconnection circuit 235. Gate electrodes of the TFT cells may be connected to a gate line through the interconnection circuit 235. This circuit configuration and operation will be described in more detail with reference to FIG. 5 below.

The lower bonding structure may include a lower bonding insulating layer 291, and lower bonding electrodes 295A-D disposed on the lower bonding insulating layer 291 and electrically connected to the driving circuit. The lower bonding electrodes 295A-D may be electrically connected to the driving circuit through the interconnection circuit 235. For example, the lower bonding electrodes 295A-D may be provided in a pillar structure. Upper surfaces of the lower bonding electrodes 295A-D may be substantially coplanar with an upper surface of the lower bonding insulating layer 291. This coplanar surface may be provided as a bonding surface for bonding to the pixel array 100 as the upper surface of the circuit board 200. The lower bonding electrodes 295 may include a conductive material such as, for example, copper (Cu). For example, the lower bonding insulating layer 291 may include at least one from among SiO, SiN, SiCN, SiOC, SiON, and SiOCN.

The lower bonding electrodes 295A-D of the circuit board 200 and the upper bonding electrodes 195A-D of the pixel array 100 may be bonded to each other to provide an electrical connection path between the circuit board 200 and the pixel array 100. Additionally, the upper bonding insulating layer 191 of the pixel array 100 may be bonded to the lower bonding insulating layer 291 of the circuit board 200.

In this manner, the circuit board 200 and the pixel array 100 may be bonded to each other by bonding of the lower bonding electrodes 295A-D and the upper bonding electrodes 195A-D and bonding of the lower bonding insulating layer 291 and the upper bonding insulating layer 191. The bonding of the lower bonding electrodes 295A-D and the upper bonding electrodes 195A-D may be, for example, copper (Cu)-copper (Cu) bonding, and the bonding of the lower bonding insulating layer 291 and the upper bonding insulating layer 191 may be dielectric-dielectric bonding, for example, dielectric-dielectric bonding such as SiCN-SiCN bonding. The circuit board 200 and the pixel array 100 may be bonded by hybrid bonding including copper (Cu)-copper (Cu) bonding and dielectric-dielectric bonding, and may be bonded without a separate adhesive layer.

Depending on a connection target, similarly to the upper bonding electrodes 195A-C, the lower bonding electrodes 295A-C may be divided into first to third lower bonding electrodes (e.g., the lower bonding electrode 295A, 295B, and 295C), respectively. Specifically, the first lower bonding electrode (e.g., the lower bonding electrode 295A) may be bonded to the first upper bonding electrode (e.g., the upper bonding electrode 195A) to electrically connect the reflective electrode 130 to the driving circuit via the common electrode 145. The second lower bonding electrodes (e.g., the lower bonding electrodes 295B) may be bonded to the second upper bonding electrodes (e.g., the upper bonding electrodes 195B), respectively, to electrically connect the connection electrode 155, which may be an individual electrode, to the driving circuit.

In this manner, by bonding of the first upper bonding electrode (e.g., (e.g., the upper bonding electrode 195A) and the first lower bonding electrode (e.g., the lower bonding electrode 295A) and bonding of the second upper bonding electrode (e.g., the upper bonding electrode 195B) and the second lower bonding electrode (e.g., the lower bonding electrode 295B), the plurality of LED cells (e.g., the first to third LED cells LC1, LC2, and LC3) may be individually driven and connected to the driving circuit. In addition, the third lower bonding electrode (e.g., the lower bonding electrode 295C) may be bonded to the third upper bonding electrode (e.g., the upper bonding electrode 195C), to electrically connect the bonding pad 199 to a driving circuit through the pad electrode 147.

In the present embodiment, the lower bonding electrodes 295 may further include a lower dummy bonding electrode 295D not connected to a driving circuit. Similarly, the upper bonding electrodes may further include an upper dummy bonding electrode 195D connected to the lower dummy bonding electrode 295D and not connected to the plurality of LED cells (e.g., the first to third LED cells LC1, LC2, and LC3). The upper dummy bonding electrode 195D and the lower dummy bonding electrode 295D may be disposed in plural and at equal intervals from the other lower bonding electrodes and the other upper bonding electrodes over an entire area. In some embodiments, the upper dummy bonding electrode 195D may be formed on a dummy pad 155D not connected to the plurality of LED cells (e.g., the first to third LED cells LC1, LC2, and LC3), and the dummy pad 155D may be formed together with the connection electrodes 155.

Referring to FIGS. 3 and 4, micro lenses 180 may be disposed on each of the first to third LED cells LC1, LC2, and LC3, to collect light emitted from the first to third LED cells LC1, LC2, and LC3. The micro lenses 180 may be configured to adjust a beam angle of light emitted from the first to third LED cells LC1, LC2, and LC3. In the present embodiment, the micro lenses 180 may be disposed on the first conductivity-type semiconductor base layer 112B. For example, the micro lenses 180 may have a diameter greater than a width of each of the plurality of LED cells (e.g., first to third LED cells LC1, LC2, and LC3) in the first horizontal direction (e.g., X-direction) and the second horizontal direction (e.g., Y-direction).

The micro lenses 180 may be formed of, for example, a transparent photoresist material or a transparent thermosetting resin film. The micro lenses 180 employed in the present embodiment may be provided to have the same shape and size as each other, but in some embodiments, they may have different shapes and/or different sizes, depending on areas of the first to third LED cells LC1, LC2, and LC3.

FIG. 5 illustrates a driving circuit implemented in a display apparatus according to an embodiment.

Referring to FIG. 5, a circuit diagram of a display apparatus 10 in which n×n sub-pixels are disposed is illustrated. First to third sub-pixels SP1, SP2, and SP3 may receive a data signal through data lines D1 to Dn, which may be vertical paths, for example, in a column direction. The first to third sub-pixels SP1, SP2, and SP3 may receive a control signal (e.g., a gate signal) through gate lines G1 to Gn, which may be horizontal paths, for example, in a row direction.

A plurality of pixels PX including the first to third sub-pixels SP1, SP2, and SP3 may provide a display region DA, and this display region DA may be provided as an active region, and may be a display region for a user. An inactive region NA (or peripheral region PA) may be formed along one or more edges of the display region DA. The inactive region NA may extend along an outer periphery of a panel of the display apparatus 10.

A first driver circuit 12 and a second driver circuit 13 may be employed to control operations of the pixels PX (e.g., the first to third sub-pixels SP1, SP2, and SP3). Some or all of the first driver circuit 12 and the second driver circuit 13 may be implemented on a circuit board 200. The first driver circuit 12 and the second driver circuit 13 may be configured as an integrated circuit, a thin film transistor panel circuit, or other suitable circuits, and may be disposed in the non-active region NA of the display apparatus 10. The first driver circuit 12 and the second driver circuit 13 may include a microprocessor, such as, for example, a processing circuit, and a communication circuit, and/or a memory such as a storage.

To display an image by the pixels PX, the first driver circuit 12 may supply image data to the data lines D1 to Dn while transmitting a clock signal and other control signals to the second driver circuit 13, which may be a gate driver circuit. The second driver circuit 13 may be implemented using an integrated circuit and/or a thin film transistor circuit. A gate signal for controlling the first to third sub-pixels SP1, SP2, and SP3 disposed in a row direction may be transmitted through the gate lines G1 to Gn of the display apparatus 10.

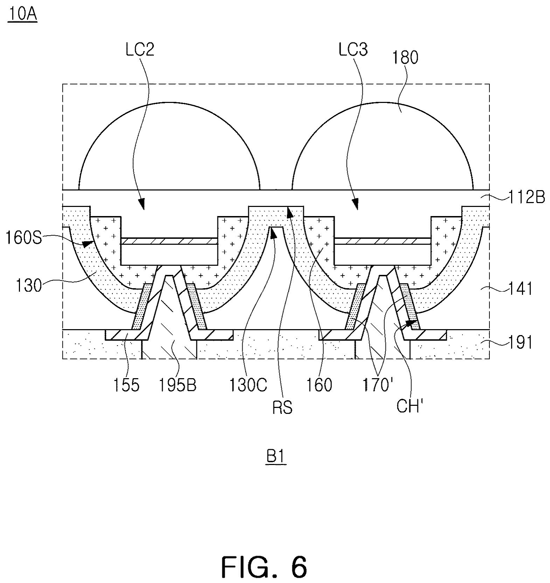

FIGS. 6 and 7 are cross-sectional views illustrating LED light source modules employed in display apparatuses according to various embodiments, respectively. The LED light source module illustrated in FIGS. 6 and 7 can be understood as a display light source employed in a pixel array as a portion of the display apparatus described with reference to FIGS. 1 to 3.

Referring to FIG. 6, it can be understood that a display apparatus 10A according to the present embodiment is similar to the display apparatus 10 illustrated in FIGS. 1 to 5, except that a structure of a contact hole CH' and a formation region of an insulating liner 170' may be different. In addition, components of the present embodiment can be understood with reference to description of the same or similar components of the display apparatus 10 illustrated in FIGS. 1 to 5, unless otherwise specifically described.

In the present embodiment, similarly to the previous embodiment, the insulating liner 170' may extend from a lower end of the contact hole CH', but may be separated from a lower surface of each of a plurality of LED cells (e.g., the first to third LED cells LC1, LC2, and LC3) by a cover portion (e.g., a second portion 160b) of a spacer 160. The insulating liner 170' may also separate a reflective electrode and a connection electrode.

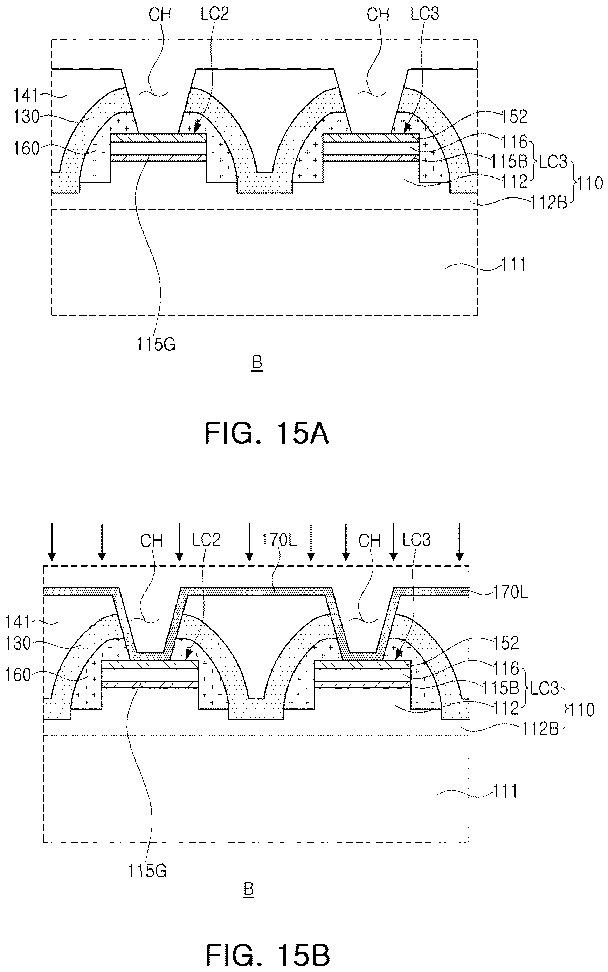

The contact hole CH' according to the present embodiment may be formed by removing a portion of the spacer 160 from a bottom of a preliminary contact hole during anisotropic etching for forming an insulating liner after forming the preliminary contact hole exposing the spacer (see FIGS. 15A to 15D). A remaining portion of the spacer 160 may protect a contact region of the plurality of LED cells (e.g., the first to third LED cells LC1, LC2, and LC3) during an anisotropic etching process. As in the present embodiment, the present embodiment may be advantageously used when the lower surface of each of the plurality of LED cells (e.g., the first to third LED cells LC1, LC2, and LC3) is directly provided by a second conductivity-type semiconductor layer 116.

Referring to FIG. 7, it can be understood that a display apparatus 10B according to the present embodiment is similar to the display apparatus 10 illustrated in FIGS. 1 to 5, except that a passivation layer 120 is added to surfaces of a plurality of LED cells (e.g., the first to third LED cells LC1, LC2, and LC3) and that side surfaces of the plurality of LED cells (e.g., the first to third LED cells LC1, LC2, and LC3) have different inclination angles. In addition, components of the present embodiment can be understood with reference to description of the same or similar components of the display apparatus 10 illustrated in FIGS. 1 to 5, unless otherwise specifically described.

In the present embodiment, a lower surface of each of the plurality of LED cells (e.g., the first to third LED cells LC1, LC2, and LC3) may have a first width W1 greater than a second width W2 of each of the plurality of LED cells (e.g., the first to third LED cells LC1, LC2, and LC3) on a lower surface of a first conductivity-type semiconductor base layer 112B. By sufficiently applying an etching process for removing a damaged layer to the plurality of LED cells (e.g., the first to third LED cells LC1, LC2, and LC3) (see FIG. 11C), side surfaces of the first to third LED cells LC1, LC2, and LC3 may have an inclination angle of less than 90° with respect to the lower surface of the first conductivity-type semiconductor base layer 112B. Therefore, the first to third LED cells LC1, LC2, and LC3 may have a structure advantageous for light extraction.

In the present embodiment, the passivation layer 120 may be disposed on the side and lower surfaces of each of the plurality of LED cells (e.g., the first to third LED cells LC1, LC2, and LC3) below a spacer 160. The passivation layer 120 may be formed up to a portion of the first conductivity-type semiconductor base layer 112B between the plurality of LED cells (e.g., the first to third LED cells LC1, LC2, and LC3). In addition, the passivation layer 120 may extend to a region of the first conductivity-type semiconductor base layer 112B located in a peripheral region PA. Specifically, the passivation layer 120 may be disposed to cover a lower surface of a first conductivity-type semiconductor layer 112 in a connection region CR and pad regions PAD (e.g., the peripheral region PA). For example, the passivation layer 120 may include an insulating material such as, for example, at least one from among SiO₂, SiN, SiCN, SiOC, SiON, SiOCN, SiOCN, HfOₓ, AlOₓ, ZrOx, and AlN. In some embodiments, the passivation layer 120 may include at least one from among ZrO₂, Al₂O₃, and HfO₂.

Referring to FIG. 7, the passivation layer 120 may include a first insulating layer 121 contacting the surfaces of the plurality of LED cells (e.g., the first to third LED cells LC1, LC2, and LC3), and a second insulating layer 125 on the first insulating layer 121. The first insulating layer 121 may be provided as a layer for curing defects on the surfaces of the plurality of LED cells (e.g., the first to third LED cells LC1, LC2, and LC3), particularly, on a side surface of a nitride epitaxial layer. For example, the first insulating layer 121 may include at least one from among ZrO₂, Al₂O₃, and HfO₂. The first insulating layer 121 may be conformally formed along the surfaces of the first to third LED cells LC1, LC2, and LC3. For example, the first insulating layer 121 may be formed by an atomic layer deposition (ALD) process. In some embodiments, the first insulating layer 121 may have a multilayer structure having a first insulating film 121a and a second insulating film 121b. The first insulating layer 121 may include a multilayer structure of, for example, ZrO₂/Al₂O₃/ZrO₂. Each layer of the multilayer structure may have a thickness of 1 nm to 10 nm. In addition, the second insulating layer 125 may include, for example, at least one from among SiO₂, SiN, SiCN, SiOC, SiON, and SiOCN.

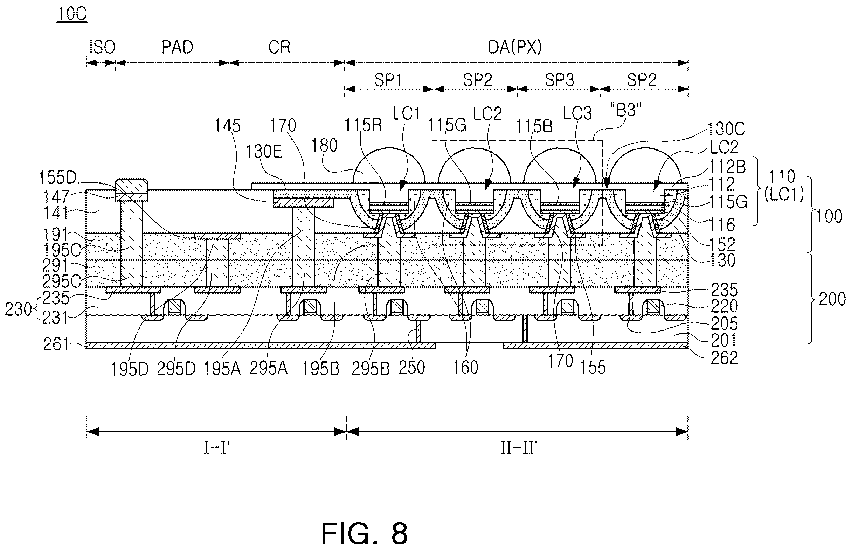

FIG. 8 is a schematic cross-sectional view illustrating a display apparatus according to an embodiment, and FIG. 9 is a partial enlarged view illustrating a portion "B3" of the display apparatus illustrated in FIG. 8.

Referring to FIGS. 8 and 9, it can be understood that a display apparatus 10C according to the present embodiment is similar to the display apparatus 10 illustrated in FIGS. 1 to 5, except that a first conductivity-type semiconductor base layer may not have a recess between a plurality of LED cells (e.g., first to third LED cells LC1, LC2, and LC3) and a spacer 160 may have a double spacer structure. In addition, components of the present embodiment can be understood with reference to description of the same or similar components of the display apparatus 10 illustrated in FIGS. 1 to 5, unless otherwise specifically described.

The spacer 160 employed in the present embodiment may include a first spacer 161 surrounding a side surface and a lower surface of each of the plurality of LED cells (e.g., the first to third LED cells LC1, LC2, and LC3) and having an inclined first side surface, and a second spacer 162 disposed on the first spacer 161 and having an inclined second side surface.

In the present embodiment, the second spacer 162 may be disposed primarily on the first side surface of the first spacer 161. The first and second side surfaces may have an inclined profile with each other. The second side surface of the second spacer 162 may have a larger inclined portion than the first side surface of the first spacer 161, and may provide an inclined side surface 160S. The first spacer 161 and the second spacer 162 may include SiO₂, SiOC, SiON, or SiOCN. In some embodiments, the first spacer 161 and the second spacer 162 may include the same material (e.g., SiO₂) as each other. In this case, an interface of the first spacer 161 and the second spacer 162 may not be visually distinguished.

Referring to FIG. 9, the inclined side surface 160S of the spacer 160 employed in the present embodiment may have an inclined portion H1, and the inclined portion H1 may extend upward from a cover portion (e.g., the second portion 160b) covering the lower surface of each of the plurality of LED cells (e.g., the first to third LED cells LC1, LC2, and LC3) of the spacer 160. A portion of the inclined side surface 160S adjacent to a first conductivity-type semiconductor base layer 112B may remain as a portion H2 that may be substantially vertical (e.g., almost vertical). The inclined portion H1 of the inclined side surface 160S of the spacer 160 may extend from the cover portion (e.g., the second portion 160b) covering the lower surface of each of the plurality of LED cells (e.g., the first to third LED cells LC1, LC2, and LC3) to at least a level higher than active layers (e.g., the first active layer 115R, the second active layer 115G, and the third active layer 115B). In some embodiments, the inclined portion H1 may have 50% or more (e.g., 80% or more) of a total height H of the inclined side surface 160S of the spacer 160.

In the present embodiment, the inclined portion H1 may be expanded by introducing the spacer 160 as a double spacer. For example, the spacer 160 having a double structure may be obtained by repeatedly depositing and etching back a spacer material (see FIGS. 13A to 13D). As a result, a light capturing effect by a reflective electrode 130 formed on the spacer 160 may be further improved.

FIGS. 10A to 10E are cross-sectional views illustrating some processes of a method for manufacturing a display apparatus according to an embodiment.

Referring to FIG. 10A, an epitaxial layer having a plurality of LED cells (e.g., first to third LED cells LC1, LC2, and LC3) may be formed on a substrate 101 for growth.

In the present process, a semiconductor underlayer 111 and a first conductivity-type semiconductor base layer 112B may be sequentially formed on the substrate 101 for growth, and then a first conductivity-type semiconductor layer 112, first to third active layers 115R, 115G, and 115B, and a second conductivity-type semiconductor layer 116 may be sequentially formed on the first conductivity-type semiconductor base layer 112B, thereby forming the plurality of LED cells (e.g., the first to third LED cells LC1, LC2, and LC3). The plurality of LED cells (e.g., the first to third LED cells LC1, LC2, and LC3) may include the first to third active layers 115R, 115G, and 115B configured to emit light of different wavelengths (e.g., colors), respectively. A contact electrode 152 may be formed on each of the second conductivity-type semiconductor layers 116.

The substrate 101 for growth may be a substrate for nitride single crystal growth. For example, the substrate 101 may include at least one from among sapphire, Si, SiC, MgAl₂O₄, MgO, LiAlO₂, LiGaO₂, and GaN. The semiconductor underlayer 111, the first conductivity-type semiconductor base layer 112B, the first to third active layers 115R, 115G, and 115B, and the second conductivity-type semiconductor layer 116 may be formed, for example, using a metal organic chemical vapor deposition (MOCVD) process, a hydrogenated vapor phase epitaxy (HVPE) process, or a molecular beam epitaxy (MBE) process.

In some embodiments, the semiconductor underlayer 111 may include a buffer layer and an undoped nitride layer (e.g., GaN). The buffer layer may be for alleviating lattice defects of the first conductivity-type semiconductor layer 112, and may include an undoped nitride semiconductor such as undoped GaN, undoped AlN, and undoped InGaN. The first conductivity-type semiconductor base layer 112B and the first conductivity-type semiconductor layer 112 may be an n-type nitride semiconductor layer such as n-type GaN. The first conductivity-type semiconductor base layer 112B may include a high concentration n-type GaN providing a contact region. The second conductivity-type semiconductor layer 116 may be a p-type nitride semiconductor layer, such as p-type GaN/p-type AlGaN. The first to third active layers 115R, 115G, and 115B may be a single quantum well structure or a multi-quantum well structure, such as InGaN/GaN. In some embodiments, the plurality of LED cells (e.g., the first to third LED cells LC1, LC2, and LC3) may be individually formed by a selective deposition process such that the first to third active layers 115R, 115G, and 115B are formed as epitaxial layers of different compositions. The contact electrode 152 may be formed on the second conductivity-type semiconductor layer 116. The contact electrode 152 may include a transparent electrode or a highly reflective ohmic contact layer.

In a selective deposition process or a dry etching process for forming the plurality of LED cells (e.g., the first to third LED cells LC1, LC2, and LC3), side surfaces of the plurality of LED cells (e.g., the first to third LED cells LC1, LC2, and LC3) may have a damaged region DR having a crystal defect.

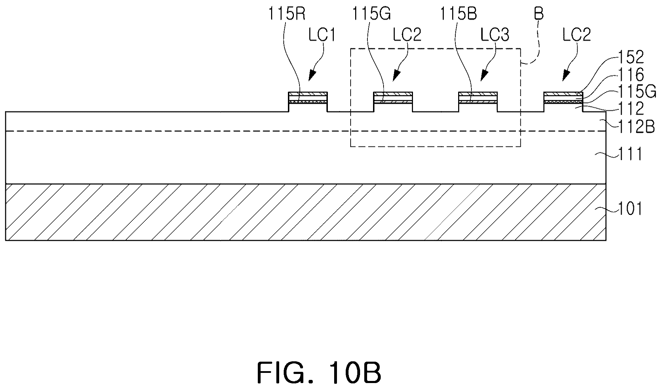

Next, referring to FIG. 10B, the damaged region DR may be removed from the side surfaces of the first to third LED cells LC1, LC2, and LC3.

The damaged region DR may cause non-radiative recombination, which may significantly reduce a light efficiency of the first to third LED cells LC1, LC2, and LC3. In the present process, the light efficiency of the first to third LED cells LC1, LC2, and LC3 may be improved by removing the damaged region DR. A process of removing the damaged region DR may be performed by wet etching, as illustrated in FIGS. 11A to 11C.

FIGS. 11A-C may be cross-sectional views illustrating an example of the process of FIG. 10A (e.g., formation of an LED cell).

First, referring to FIG. 11A, a mask 165 may be formed on the first to third LED cells LC1, LC2, and LC3 illustrated in FIG. 10A. The mask 165 may be formed on the contact electrode 152. For example, the mask 165 may include SiO₂, SiOC, SiON, or SiOCN.

Then, referring to FIG. 11B, the mask 165 may be used to apply wet etching to remove the damaged region DR. For example, the wet etching may use a KOH solution or a TMAH solution. After removing the damaged region DR, cross-sections of the first to third LED cells LC1, LC2, and LC3 may be changed from a trapezoid to a rectangle. During a wet etching process, the damaged regions DR may be removed, and the side surfaces of the first to third LED cells LC1, LC2, and LC3 may have stable crystal planes. For example, the first to third LED cells LC1, LC2, and LC3 may have nearly vertical side surfaces (e.g., m-planes). As a result, as illustrated in FIG. 10B, the plurality of LED cells respectively having a cross-section, which is almost rectangular, may be obtained.

Optionally, side profiles of the first to third LED cells LC1, LC2, and LC3 may be changed by additionally applying this wet etching process. As illustrated in FIG. 11C, the cross-sections of the first to third LED cells LC1, LC2, and LC3 may have an inverted trapezoidal shape from the rectangle by additional wet etching. An inclination angle θ of side surfaces of inverted trapezoids of the first to third LED cells LC1, LC2, and LC3 may be less than 90° with respect to the lower surface of the first conductivity-type semiconductor base layer 112B. This inverted trapezoidal cell structure may be combined with a reflective electrode 130 (e.g., a bowl-shaped reflective electrode) to further improve a reflection effect (see FIG. 7).

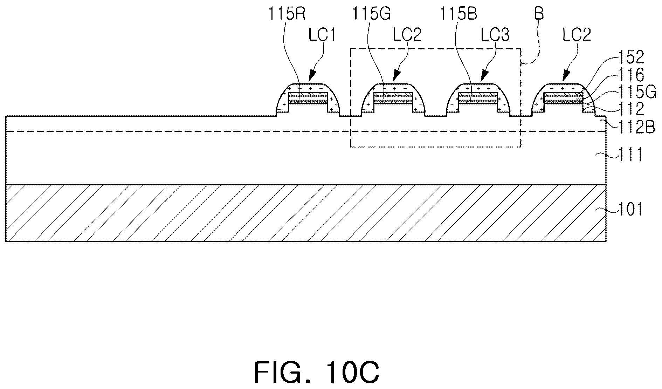

Next, referring to FIG. 10C, spacers 160 covering the plurality of LED cells (e.g., the first to third LED cells LC1, LC2, and LC3) may be formed.

The spacers 160 surrounding the side and upper surfaces of the plurality of LED cells (e.g., the first to third LED cells LC1, LC2, and LC3) may be formed. As described with respect to the above embodiments, the spacers 160 may have inclined side surfaces 160S. A process of forming the spacers 160 employed in the present embodiment may be described with reference to FIGS. 12A to 12D. FIGS. 12A to 12D are cross-sectional views illustrating an example of the process of FIG. 10B (e.g., formation of a spacer).

Referring to FIG. 12A, a spacer material layer 160L may be formed on the first conductivity-type semiconductor base layer 112B to cover the plurality of LED cells (e.g., the first to third LED cells LC1, LC2, and LC3). The spacer material layer 160L may be formed to cover the upper and side surfaces of the first to third LED cells LC1, LC2, and LC3, and may also be formed on the upper surface of the first conductivity-type semiconductor base layer 112B. For example, the spacer 160 may include SiO₂, SiOC, SiON, or SiOCN. In the present embodiment, the spacer material layer 160L may be conformally formed along the surfaces of the first to third LED cells LC1, LC2, and LC3 having a rectangular cross-section. In the cross-section illustrated in FIG. 12A, the spacer material layer 160L may also have a rectangular outer shape. For example, the spacer material layer 160L may be obtained by repeatedly performing an ALD process until a desired thickness is obtained.

Then, referring to FIG. 12B, a mask pattern PR may be formed in each of regions of the spacer material layer 160L corresponding to the upper surfaces of the first to third LED cells LC1, LC2, and LC3. The mask pattern PR employed in the present process may have an inclined side surface, and may include a photoresist pattern. A portion of the spacer material layer 160L on the side surfaces of the first to third LED cells LC1, LC2, and LC3 may be located below the inclined side surface of the mask pattern PR. This process may be performed by anisotropic etching such as reactive ion etching while the mask pattern PR is applied. In this etching process, the mask pattern PR may be removed together with the portion of the spacer material layer 160L between the first to third LED cells LC1, LC2, and LC3. In a process of removing the mask pattern PR, the portion of the spacer material layer 160L below the inclined side surface of the mask pattern PR may be partially removed to have the inclined side surface 160S.

As a result, as illustrated in FIG. 12C, the spacer 160 may include a first portion 160a covering the side surface of each of the plurality of LED cells (e.g., the first to third LED cells LC1, LC2, and LC3), and a second portion 160b covering the upper surface of each of the plurality of LED cells (e.g., the first to third LED cells LC1, LC2, and LC3). The first portion 160a may have a thickness increasing toward the first conductivity-type semiconductor base layer 112B, and the second portion 160b may be a portion located below a flat portion of the mask pattern, and may have an almost constant thickness.

Optionally, referring to FIG. 12D, the first conductivity-type semiconductor base layer 112B may be additionally etched using the spacer 160 as a mask, to form a recess RS. In the present embodiment, by additionally applying the present process, a region of the first conductivity-type semiconductor base layer 112B provided as a bottom of the recess RS between the spacers 160 may be formed, which may be provided as a contact region for a reflective electrode to be formed in a subsequent process. Since the process for recess may additionally etch to a depth reaching the contact region, the first to third LED cells LC1, LC2, and LC3 may be formed to have a relatively small height. For example, an aspect ratio of the first to third LED cells LC1, LC2, and LC3 may be 1 or less to have a stable structure.

In some embodiments, a process of forming the spacer may be performed by other processes. For example, a process of forming the double spacer employed in the display apparatus 10C illustrated in FIGS. 8 and 9 may be performed by processes illustrated in FIGS. 13A to 13D.

Referring to FIG. 13A, a first spacer material layer 161L may be formed on the first conductivity-type semiconductor base layer 112B to cover the upper and side surfaces of the first to third LED cells LC1, LC2, and LC3. Then, referring to FIG. 13B, anisotropic etching may be applied to the first spacer material layer 161L. For example, by applying etch-back to the first spacer material layer 161L, a processed first spacer 161 having rounded corners of the upper surfaces of the first to third LED cells LC1, LC2, and LC3 may be formed. In the present process, portions of the first spacer material layer 161L between the LED cells may be removed. Finally, a first side surface 161S of the first spacer 161 may have a slightly inclined curved surface at least in an upper region.

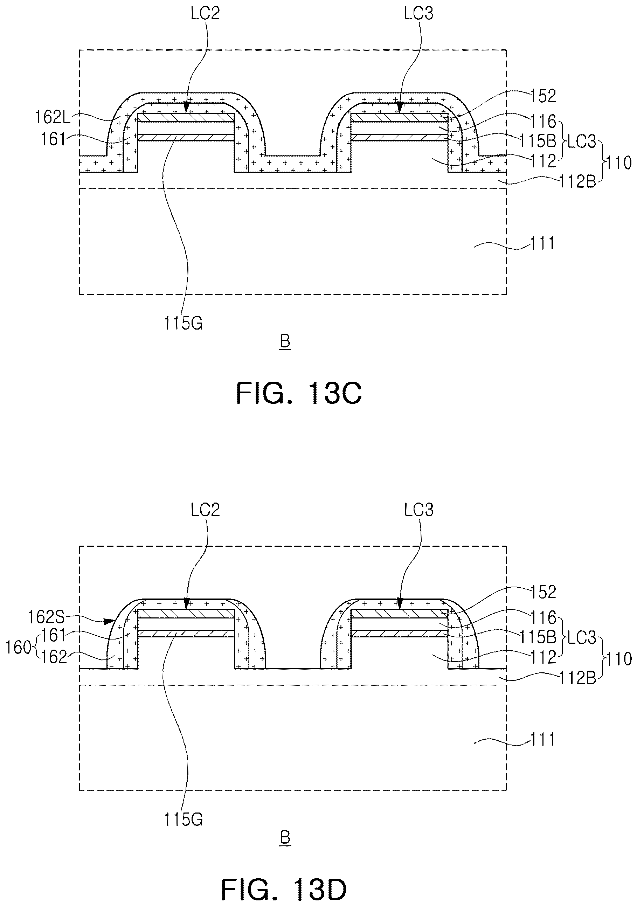

Next, referring to FIG. 13C, similar to the process of FIG. 13A, a second spacer material layer 162L may be deposited on the first to third LED cells LC1, LC2, and LC3 on which the first spacer 161 is formed. The second spacer material layer 162L may be formed to cover the upper and side surfaces of the first to third LED cells LC1, LC2, and LC3, and may also be formed on the upper surface of the first conductivity-type semiconductor base layer 112B. The second spacer material layer 162L may be disposed on the inclined first side surface of the first spacer 161, and may thus have an inclined sidewall corresponding to the first side surface.

Next, referring to FIG. 13D, similarly to the process of FIG. 13B, a second etch-back process may be applied to the second spacer material layer 162L. For example, by performing the second etch-back process until a portion of the second spacer material layer 162L located on the upper surface of the first conductivity-type semiconductor base layer 112B is removed, a second spacer 162 may have a second side surface 162S, which is more inclined than the first side surface 161S. As a result, a spacer 160 may have a sufficiently inclined sidewall.

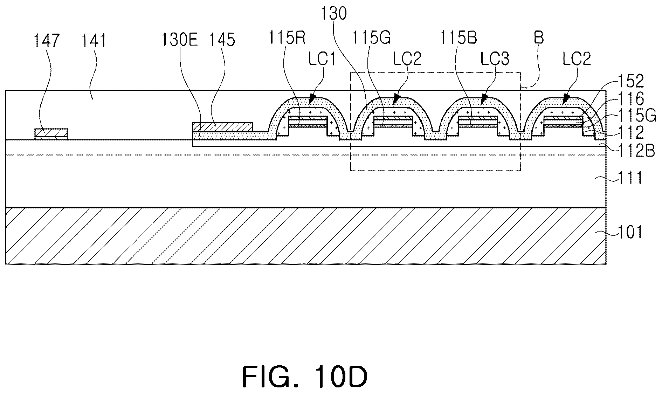

Next, referring to FIG. 10D, a reflective electrode 130 may be formed on each of the plurality of LED cells (e.g., the first to third LED cells LC1, LC2, and LC3), and a common electrode 145 and a pad electrode 147 may be formed in a peripheral region of a semiconductor stack 110. Next, a gap-fill insulating layer 141 may be formed on the first conductivity-type semiconductor base layer 112B to cover the first to third LED cells LC1, LC2, and LC3 and the reflective electrode 130.

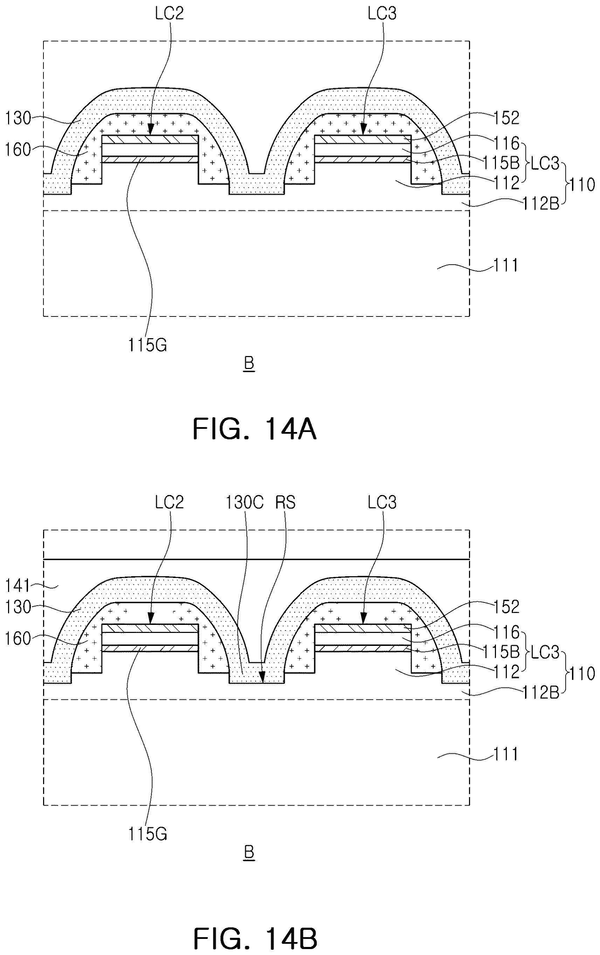

First, the reflective electrode 130 may be formed on the spacers 160 and a region of the first conductivity-type semiconductor base layer 112B between the spacers 160 (see FIG. 14A). The reflective electrode 130 may have bowl-shaped reflective structures according to the inclined side surface of the spacer 160. The reflective electrode 130 may be electrically connected to a region of the first conductivity-type semiconductor base layer 112B between the plurality of LED cells (e.g., the first to third LED cells LC1, LC2, and LC3). Next, the common electrode 145 and the pad electrode 147 may be formed on a connection region CR and pad regions PAD, respectively. The common electrode 145 may be connected to the first conductivity-type semiconductor base layer 112B. The common electrode 145 may be formed on an extension portion 130E of the reflective electrode 130. The common electrode 145 and the pad electrode 147 may be formed together by the same process.

A portion of the reflective electrode 130 located on the upper surface of the plurality of LED cells (e.g., the first to third LED cells LC1, LC2, and LC3) may be removed, and the gap-fill insulating layer 141 may be formed to cover the upper surface of the semiconductor stack 110 on which the reflective electrode 130 is formed (see FIG. 14B). The gap-fill insulating layer 141 may be formed to cover the upper surface of the semiconductor stack 110 on which the reflective electrode 130 is formed, and then a process of planarizing the gap-fill insulating layer 141 may be performed using a planarization process such as a chemical mechanical polishing (CMP) process or an etch-back process. For example, the gap-fill insulating layer 141 may be formed of silicon oxide, as described above.

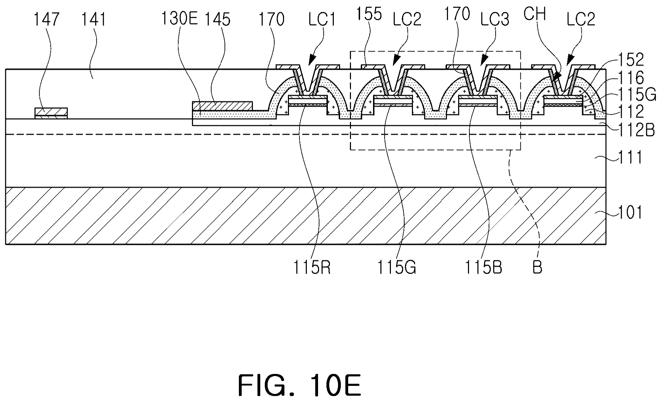

Next, referring to FIG. 10E, a contact hole CH penetrating the gap-fill insulating layer 141, the reflective electrode 130, and the spacer 160 may be formed, and an insulating liner 170 may be formed on an inner sidewall of the contact hole CH, and then connection electrodes 155 connected to the contact electrodes 152 may be formed.

This process may be performed by the self-align process illustrated in FIGS. 15A to 15D.

First, referring to FIG. 15A, the contact hole CH penetrating the gap-fill insulating layer 141, the reflective electrode 130, and the spacer 160 may be formed. In the present embodiment, the contact hole CH may be formed such that a portion of the contact electrode 152 may be exposed. This contact hole CH may be performed by an etching process. For example, the etching process may be performed by a combination of a plurality of etching processes or a single etching process depending on a material. The reflective electrode 130 may be exposed on the inner sidewall of the contact hole CH. The exposed portion of the reflective electrode 130 may be configured to surround the contact hole CH.

Next, referring to FIG. 15B, a liner material layer 170L may be conformally formed on an upper surface of the gap-fill insulating layer 141 and inner surfaces of the contact hole CH. Inside the contact hole CH, the liner material layer 170L may be formed to cover not only the inner sidewall of the contact hole CH, but also a portion of the contact electrode 152 located on a bottom of the contact hole CH. For example, the liner material layer 170L may include SiO₂, SiN, SiCN, SiC, SiCOH, SiON, Al₂O₃, AlN, or a combination thereof. For example, the present process may be performed by an ALD process.

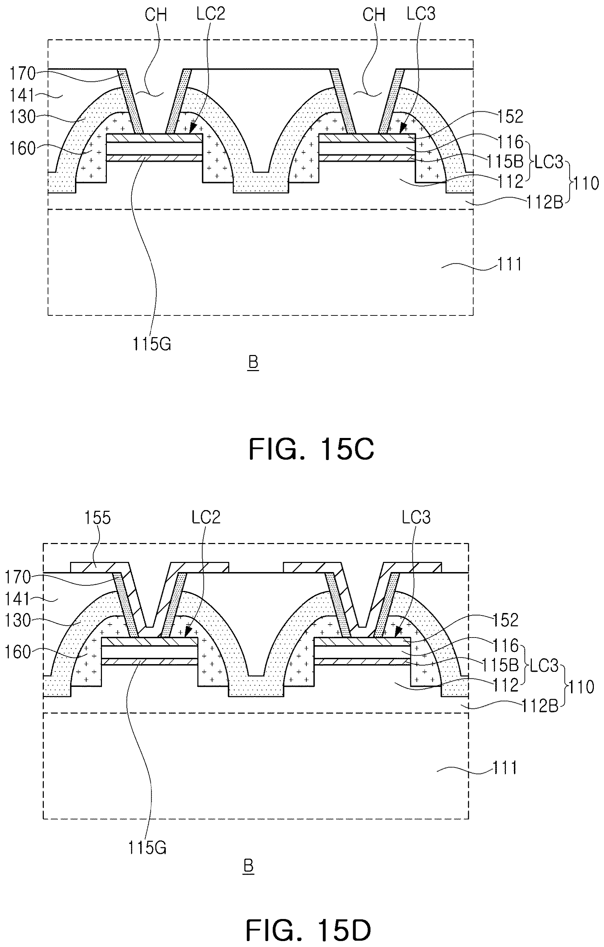

Next, referring to FIG. 15C, an insulating liner 170 may be formed on the inner sidewall of the contact hole CH by partially removing the liner material layer 170L. In the present process, portions of the liner material layer 170L on the upper surface of the gap-fill insulating layer 141 and the bottom of the contact hole CH may be removed using an anisotropic etching process. As a result, a portion of the contact electrode 152 on the bottom of the contact hole CH may be exposed again, and the insulating liner 170 may be self-aligned on the inner sidewall of the contact hole CH. In the present embodiment, the insulating liner 170 may extend from an upper end of the contact hole CH to the contact electrode 152.

Next, referring to FIG. 15D, connection electrodes 155 connected to the contact electrodes 152 of each of the plurality of LED cells (e.g., the first to third LED cells LC1, LC2, and LC3) may be formed in the contact holes CH. The connection electrode 155 may be electrically connected to the second conductivity-type semiconductor layer 116 through the contact electrode 152. The connection electrode 155 may include a pad located on the lower surface of the gap-fill insulating layer 141. The pad of the connection electrode 155 may have a width greater than a width of each of the plurality of LED cells (e.g., the first to third LED cells LC1, LC2, and LC3). In this manner, the pad of the connection electrode 155 may be provided as a complementary reflective structure for a small amount of light leaking through the insulating liner 170.

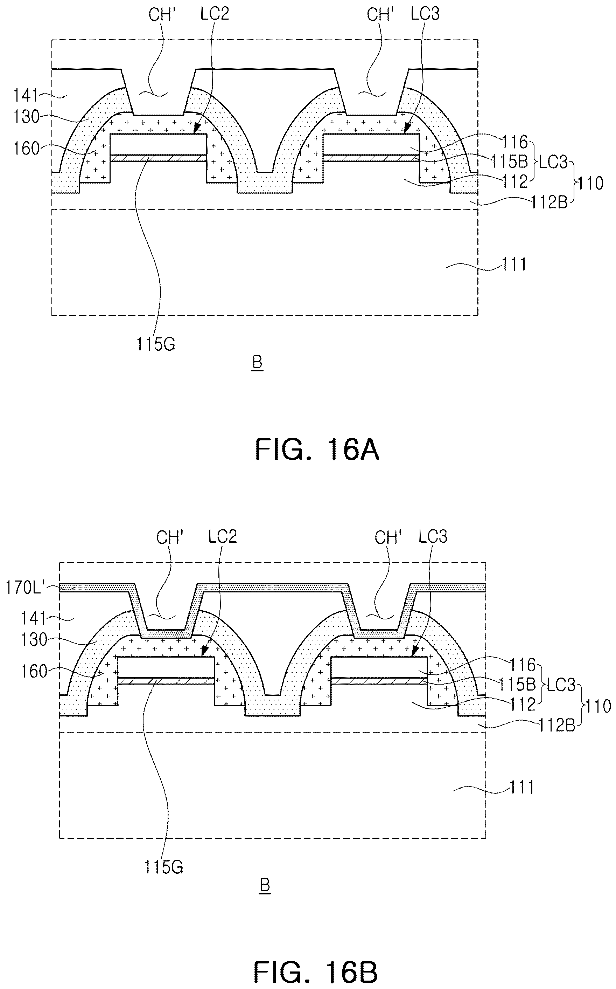

In some embodiments, the process of forming the connection electrode may be performed by other processes. For example, a process of forming the insulating liner 170' employed in the display apparatus 10A illustrated in FIG. 6 may be performed by the processes illustrated in FIGS. 16A to 16D.

First, referring to FIG. 16A, a contact hole CH' penetrating the gap-fill insulating layer 141 and the reflective electrode 130 may be formed. In the present embodiment, the contact hole CH' may be formed such that a portion of the spacer 160 may be exposed. In the present process, etching for removing the gap-fill insulating layer 141 and etching for removing the reflective electrode 130 may be performed sequentially. In the present embodiment as well, the reflective electrode 130 may be exposed on an inner sidewall of the contact hole CH'.

Next, referring to FIG. 16B, a liner material layer 170L' may be conformally formed on the upper surface of the gap-fill insulating layer 141 and the inner surfaces of the contact hole CH'. The liner material layer 170L' inside the contact hole CH' may be formed to cover the inner sidewall of the contact hole CH' and a portion of the spacer 160 exposed at the bottom of the contact hole CH'.

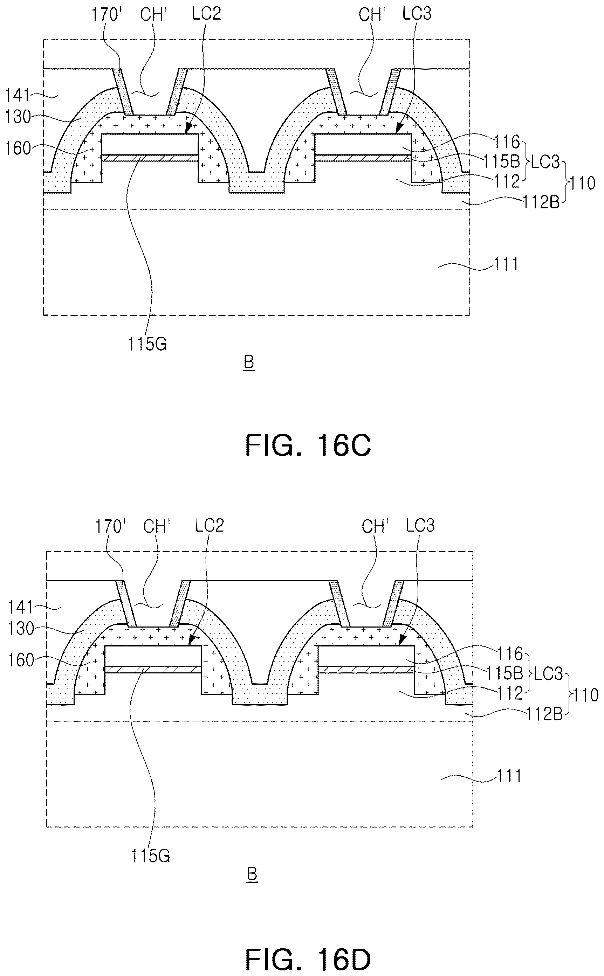

Next, referring to FIG. 16C, an insulating liner 170' may be formed on the inner sidewall of the contact hole CH' by partially removing the liner material layer 170L'. In the present process, portions of the liner material layer 170L' on the upper surface of the gap-fill insulating layer 141 and the bottom of the contact hole CH' may be removed using an anisotropic etching process. In this etching process, a portion of the spacer layer may be exposed to the bottom of the contact hole CH', and an exposed portion of the spacer 160 may also be etched to open the contact region on the upper surface of the first to third LED cells LC1, LC2, and LC3. The insulating liner 170' may extend from the upper surface of the contact hole CH', but may be separated from a contact region on the upper surface of the first to third LED cells LC1, LC2, and LC3 by the spacer 160.

Next, referring to FIG. 16D, connection electrodes 155 connected to the contact electrodes 152 of each of the plurality of LED cells (e.g., the first to third LED cells LC1, LC2, and LC3) may be formed in the contact holes CH. The connection electrode 155 may be electrically connected to the second conductivity-type semiconductor layer 116 through the contact electrode 152. In the present embodiment, the connection electrode 155 may be electrically separated from the reflective electrode 130 by the insulating liner 170'.

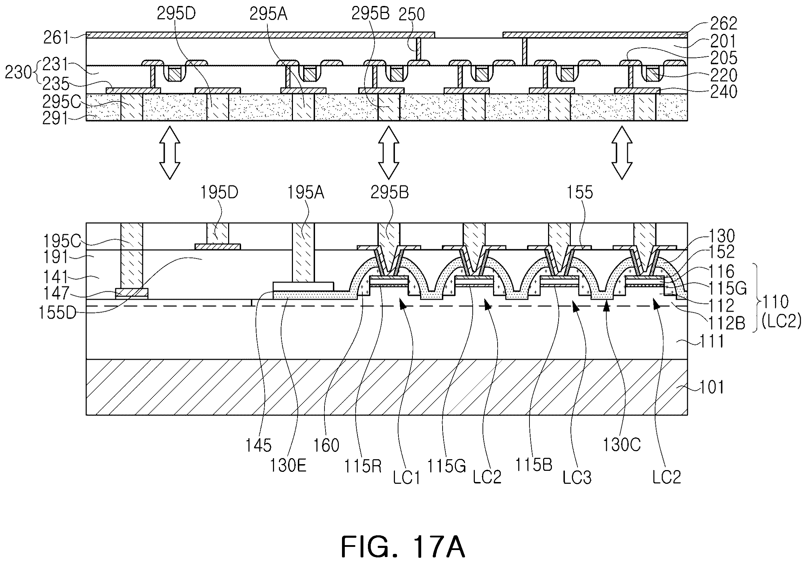

FIGS. 17A to 17C are cross-sectional views illustrating other processes of a method for manufacturing a display apparatus according to an embodiment.

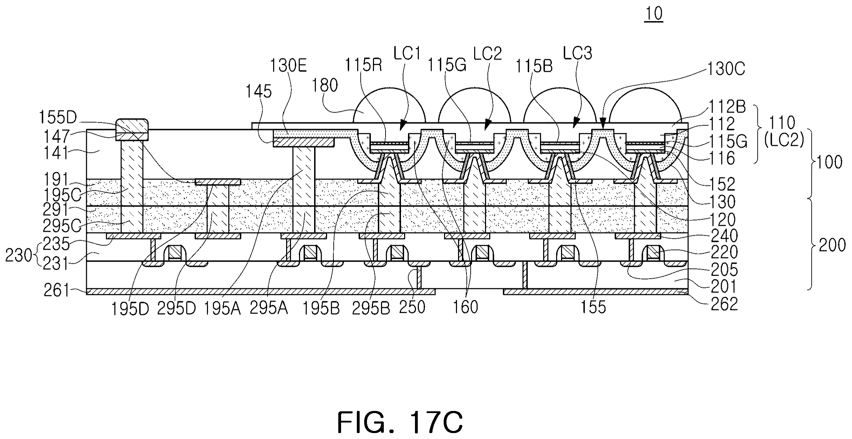

First, referring to FIG. 17A, a pixel array structure including first to third LED cells LC1, LC2, and LC3 may be bonded to a circuit board 200 (see FIG. 17C).

The circuit board 200 may be prepared by a separate process. A pixel array 100 (see FIG. 17C) and the circuit board 200 may be bonded on a wafer level by a wafer bonding method such as, for example, the hybrid bonding described above. The circuit board 200 may include a lower bonding structure having a lower bonding insulating layer 291 and lower bonding electrodes 295A-D, as described above. The lower bonding electrodes 295A-D may be bonded to upper bonding electrodes 195A-D, and the lower bonding insulating layer 291 may be bonded to an upper bonding insulating layer 191. In this manner, the pixel array 100 including the first to third LED cells LC1, LC2, and LC3 and the circuit board 200 may be bonded without a separate adhesive layer.

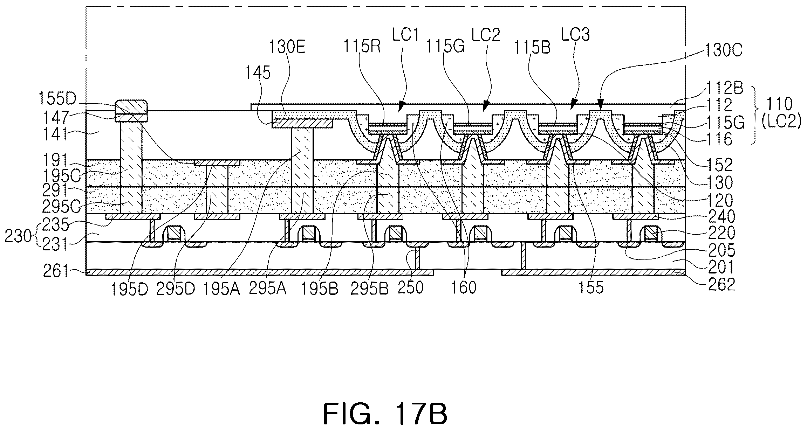

Next, referring to FIG. 17B, a substrate 101 (see FIG. 17A) for growth may be removed, and a portion of a semiconductor stack 110 (e.g., a semiconductor underlayer 111) may be removed.

The substrate 101 for growth may be removed by various processes such as laser lift-off, mechanical polishing or mechanical chemical polishing, and an etching process. The semiconductor underlayer 111 may be partially removed to be reduced to a predetermined thickness using, for example, a polishing process such as CMP. After removing the semiconductor underlayer 111, a first conductivity-type semiconductor base layer 112B may be exposed. Additionally, the first conductivity-type semiconductor base layer 112B located in a pad region PAD may be removed.

Then, referring to FIG. 17C, the display apparatus 10 illustrated in FIGS. 3 and 4 may be manufactured by additionally forming micro lenses 180 and bonding pads.

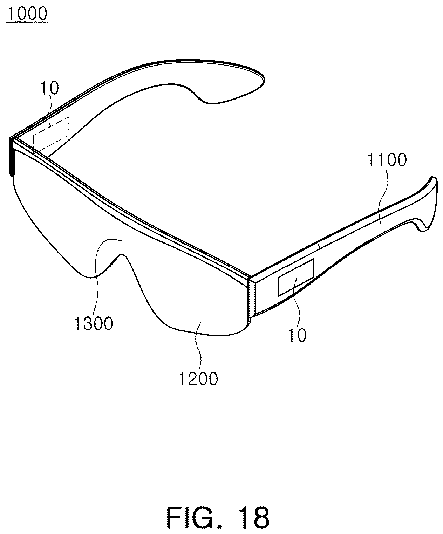

FIG. 18 is a schematic diagram of an electronic device including a display apparatus according to an embodiment.

Referring to FIG. 18, an electronic device 1000 according to the present embodiment may be a glasses-type display, which may be a wearable device. The electronic device 1000 may include a pair of temples 1100, a pair of optical coupling lenses 1200, and a bridge 1300. The electronic device 1000 may further include a display apparatus (e.g., the display apparatuses 10, 10A, 10B, and 10C) including an image generating unit.

The electronic device 1000 may be a virtual reality (VR) device, an augmented reality (AR) device, or a mixed reality (MR) device, having a head-mounted type, a glasses-type, or a goggle-type, that may provide virtual reality or may provide virtual images and external real landscapes together.

The temples 1100 may extend in one direction. The temples 1100 may extend in parallel and spaced apart from each other. The temples 1100 may be folded toward the bridge 1300 using a hinge connection. The bridge 1300 may be provided between the optical coupling lenses 1200, to connect the optical coupling lenses 1200 to each other. The optical coupling lenses 1200 may include a light guide plate. The display apparatuses 10, 10A, 10B, and 10C may be respectively disposed in a portion of the temples 1100 adjacent to the optical coupling lenses 1200, and may generate an image on the optical coupling lenses 1200. In some embodiments, the display apparatuses 10, 10A, 10B, and 10C may be disposed in a region of the optical coupling lenses 1200.

A reflective electrode having a shape, similar to a bowl, may be formed on each of micro-sized LED cells in a manner that minimizes light leakage while preventing unwanted contact with a different electrode. Such a reflective structure may adjust a beam angle of each of the LED cells to collect light, and may increase light efficiency in a desired region.

Various advantages and effects of embodiments of the present disclosure are not limited to the above-described contents, and other advantages of effects of embodiments of the present disclosure will be understood based on the above descriptions.

While non-limiting example embodiments have been illustrated and described above, it will be apparent to those skilled in the art that modifications and variations could be made without departing from the scope of the present invention as defined according to the appended claims.

Embodiments are set out in the following clauses.
Clause 1. A display apparatus comprising:
   a semiconductor stack comprising:
      a first conductivity-type semiconductor base layer comprising an upper surface configured as a light emitting surface; and
      a light-emitting diode (LED) cell on a lower surface of the first conductivity-type semiconductor base layer, the LED cell comprising an active layer and a second conductivity-type semiconductor layer, sequentially stacked on the lower surface of the first conductivity-type semiconductor base layer;
   a spacer on a side surface and a lower surface of the LED cell, the spacer comprising an inclined outer sidewall;
   a reflective electrode on the spacer and connected to the first conductivity-type semiconductor base layer;
   a gap-fill insulating layer on a lower surface of the semiconductor stack and on the reflective electrode;
   a connection electrode connected to the second conductivity-type semiconductor layer of the LED cell through a contact hole penetrating the gap-fill insulating layer, the reflective electrode, and the spacer; and
   an insulating liner disposed along an inner sidewall of the contact hole, and electrically insulating the connection electrode and the reflective electrode.
Clause 2. The display apparatus of clause 1, wherein the insulating liner is in the contact hole and does not extend to the gap-fill insulating layer.
Clause 3. The display apparatus of clause 1 or 2, wherein, in a cross section taken along a plane extending in a thickness direction of the semiconductor stack, the insulating liner comprises a first portion and a second portion that face each other on an inner side wall of the contact hole, and a thickness deviation between the first portion and the second portion is 10% or less.
Clause 4. The display apparatus of any preceding clause, wherein the insulating liner extends from a lower end of the contact hole to the lower surface of the LED cell.
Clause 5. The display apparatus of any preceding clause, wherein the LED cell further comprises a contact electrode on a lower surface of the second conductivity-type semiconductor layer.
Clause 6. The display apparatus of any one of clauses 1 to 3 or 5, wherein the insulating liner extends from a lower end of the contact hole toward the LED cell, and is separated from the LED cell by the spacer.
Clause 7. The display apparatus of any preceding clause, wherein the lower surface of the LED cell is defined by the second conductivity-type semiconductor layer, and the connection electrode is connected to the second conductivity-type semiconductor layer.
Clause 8. The display apparatus of any preceding clause, wherein the first conductivity-type semiconductor base layer comprises a recess between the LED cell and an adjacent LED cell, and
   wherein the reflective electrode is connected to a region of the first conductivity-type semiconductor base layer exposed at a bottom of the recess.
Clause 9. The display apparatus of any preceding clause, wherein the side surface of the LED cell is vertical with respect to the lower surface of the first conductivity-type semiconductor base layer.
Clause 10. The display apparatus of any one of clauses 1 to 8, wherein the lower surface of the LED cell has a first width that is greater than a second width of the LED cell on the lower surface of the first conductivity-type semiconductor base layer.
Clause 11. The display apparatus of any preceding clause, wherein the connection electrode comprises:
   a via in the contact hole; and
   a pad connected to the via, the pad being on the lower surface of the gap-fill insulating layer.
Clause 12. The display apparatus of clause 11, wherein the pad of the connection electrode has a width that is greater than a width of the LED cell.
Clause 13. The display apparatus of any preceding clause, wherein at least one from among the reflective electrode and the connection electrode comprises at least one from among Ag, Cr, Ni, Ti, Al, Rh, and Ru.
Clause 14. The display apparatus of any preceding clause, wherein the spacer comprises:
   a first portion on the side surface of the LED cell; and
   a second portion on the lower surface of the LED cell,
   wherein the first portion has a thickness increasing toward the first conductivity-type semiconductor base layer.
Clause 15. The display apparatus of clause 14, wherein a portion of the spacer adjacent to a lower edge of the LED cell has a thickness that is smaller than a thickness of each of the first portion and the second portion.

## Claims

1. A display apparatus (10) comprising:
a semiconductor stack (110) comprising:
a first conductivity-type semiconductor base layer (112B) comprising an upper surface configured as a light emitting surface; and
a light-emitting diode (LED) cell (LC1, LC2, LC3) on a lower surface of the first conductivity-type semiconductor base layer (112B), the LED cell (LC1, LC2, LC3) comprising an active layer (115R, 115G, 115B) and a second conductivity-type semiconductor layer (116), sequentially stacked on the lower surface of the first conductivity-type semiconductor base layer (112B);
a spacer (160) on a side surface and a lower surface of the LED cell (LC1, LC2, LC3), the spacer (160) comprising an inclined outer sidewall (160S);
a reflective electrode (130) on the spacer (160) and connected to the first conductivity-type semiconductor base layer (112B);
a gap-fill insulating layer (141) on a lower surface of the semiconductor stack (110) and on the reflective electrode (130);
a connection electrode (155) connected to the second conductivity-type semiconductor layer (116) of the LED cell (LC1, LC2, LC3) through a contact hole (CH) penetrating the gap-fill insulating layer (141), the reflective electrode (130), and the spacer (160); and
an insulating liner (170) disposed along an inner sidewall of the contact hole (CH), and electrically insulating the connection electrode (155) and the reflective electrode (130).

2. The display apparatus (10) of claim 1, wherein the insulating liner (170) is in the contact hole (CH) and does not extend on a lower surface of the gap-fill insulating layer (141).

3. The display apparatus (10) of claim 1 or 2, wherein, in a cross-section taken along a plane extending in a thickness direction of the semiconductor stack (110), the insulating liner (170) comprises a first portion and a second portion that face each other on an inner side wall of the contact hole (CH), and a thickness deviation (t1-t2) between the first portion and the second portion is 10% or less.

4. The display apparatus (10) of any preceding claim, wherein the insulating liner (170) extends from a lower end of the contact hole (CH) to the lower surface of the LED cell (LC1, LC2, LC3).

5. The display apparatus (10A) of any one of claims 1 to 3, wherein the insulating liner (170') extends from a lower end of the contact hole (CH') toward the LED cell (LC1, LC2, LC3), and is separated from the LED cell (LC1, LC2, LC3) by the spacer (160).

6. The display apparatus (10) of any preceding claim, wherein the LED cell (LC1, LC2, LC3) further comprises a contact electrode (152) on a lower surface of the second conductivity-type semiconductor layer (116).

7. The display apparatus (10) of any preceding claim, wherein the lower surface of the LED cell (LC1, LC2, LC3) is defined by the second conductivity-type semiconductor layer (116), and the connection electrode (155) is connected to the second conductivity-type semiconductor layer (116).

8. The display apparatus (10) of any preceding claim, wherein the first conductivity-type semiconductor base layer (112B) comprises a recess (RS) between the LED cell (LC1, LC2, LC3) and an adjacent LED cell (LC1, LC2, LC3), and
wherein the reflective electrode (130) is connected to a region of the first conductivity-type semiconductor base layer (112B) exposed at a bottom of the recess (RS).

9. The display apparatus (10) of any preceding claim, wherein the side surface of the LED cell (LC1, LC2, LC3) is vertical with respect to the lower surface of the first conductivity-type semiconductor base layer (112B).

10. The display apparatus (10B) of any one of claims 1 to 8, wherein the lower surface of the LED cell (LC1, LC2, LC3) has a first width (W1) that is greater than a second width (W2) of the LED cell (LC1, LC2, LC3) on the lower surface of the first conductivity-type semiconductor base layer (112B).

11. The display apparatus (10) of any preceding claim, wherein the connection electrode (155) comprises:
a via (155V) in the contact hole (CH); and
a pad (155P) connected to the via (155V), the pad (155P) being on the lower surface of the gap-fill insulating layer (141).

12. The display apparatus (10) of claim 11, wherein the pad (155P) of the connection electrode (155) has a width (S2) that is greater than a width (S1) of the LED cell (LC1, LC2, LC3).

13. The display apparatus (10) of any preceding claim, wherein at least one from among the reflective electrode (130) and the connection electrode (155) comprises at least one from among Ag, Cr, Ni, Ti, Al, Rh, and Ru.

14. The display apparatus (10) of any preceding claim, wherein the spacer (160) comprises:
a first portion (160a) on the side surface of the LED cell (LC1, LC2, LC3); and
a second portion (160b) on the lower surface of the LED cell (LC1, LC2, LC3),
wherein the first portion (160a) has a thickness (d1) increasing toward the first conductivity-type semiconductor base layer (112B).

15. The display apparatus (10) of claim 14, wherein a portion of the spacer (160) adjacent to a lower edge of the LED cell (LC1, LC2, LC3) has a thickness (d3) that is smaller than a thickness (d1) of the first portion (160a) and that is smaller than a thickness (d2) of the second portion (160b).
